# EUROPEAN PATENT APPLICATION

(11) **EP 3 901 194 A1**
(43) Date of publication of application: **27.10.2021**
(21) Application number: 19898449.4
(22) Date of filing: 20.12.2019
(51) Int. Cl.: C08G 73/02, H01L 51/42, H01L 27/144, H01L 27/146, H01L 27/30

(54) **ORGANIC PHOTODIODE AND INFRARED CMOS SENSOR**

(30) Priority: 20.12.2018 JP 2018238473
(71) Applicant: Mitsubishi Chemical Corporation, Chiyoda-ku Tokyo 100-8251 (JP)
(72) Inventor: OKABE, Kazuki, Tokyo 100-8251 (JP)
(74) Representative: Hoffmann Eitle
(86) International application number: PCT/JP2019/050075
(87) International publication number: WO 2020/130133

(57) **Abstract**

There are provided an organic photodiode having high photoelectric conversion efficiency and a low dark current value and an infrared CMOS sensor including the organic photodiode. The organic photodiode includes, in sequence, a first electrode, a hole transport layer, a photoelectric conversion layer, and a second electrode. The photoelectric conversion layer contains a p-type semiconductor and an n-type semiconductor. The hole transport layer contains a polymer compound containing a repeat unit represented by formula (2) illustrated below. The polymer compound contains groups that form mutual bonds between carbon atoms of side chains of molecules of the polymer compound at 230°C.

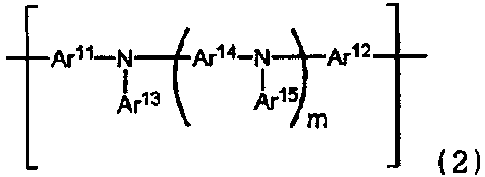

## Description

### Technical Field

The present invention relates to an organic photodiode (organic photoelectric conversion element) and an infrared CMOS sensor including the organic photodiode, and specifically, to an organic photodiode having both high photoelectric conversion efficiency and a low dark current value and an infrared CMOS sensor including this organic photodiode.

### Background Art

CMOS image sensors are used as image-pickup devices for digital cameras and smartphones. In recent years, CMOS sensors have been required to have high sensitivity that enables capture of images even at low light, high dynamic ranges that enable simultaneous capture of images with highlights and shadows, a simultaneous exposure and readout (global shutter) function, high frame rates that enable tracking of subjects moving at high speed, and so forth.

Organic photoelectric conversion films are considered to be suitable for CMOS sensor applications in the following respects.
- Organic photoelectric conversion films can have smaller thickness than Si photodiodes. This allows for a large incident angle; thus, a small amount of light can be reliably photoelectrically converted.
- Signal storage portion and a photoelectric conversion portion can be independently designed; thus, the signal storage portion can have higher capacity, making it easier to achieve a high dynamic range.
- The signal storage portion can be used as memory.

Recently, there has been an increasing demand for CMOS sensors including organic photoelectric conversion films for machine vision. In images different from visible-light images, in particular, CMOS sensors using near-infrared radiation are expected to be used, for example, for the detection of people on roads at night that are difficult to see with the naked eye, the determination of the harvest levels of crops from images of fields, a security application where observation beyond a wall, which appears merely black to the naked eye, therethrough. This is due in part to the fact that sensors using silicon have low sensitivity in the infrared region, and the use of organic photoelectric conversion films is considered preferable.

CMOS sensors including organic photoelectric conversion films can have a smaller thickness. The smaller thickness, however, results in the occurrence of problems, such as a short circuit in an element and leakage current (dark current). The smoothing of an electrode has a great effect on the short circuit in the element. For example, a coating film is disposed on the electrode to provide a short-circuit prevention effect.

The arrangement of the coating film is also effective against the generation of the dark current. To sufficiently provide the effect of reducing the dark current, however, a conventionally known coating film needs to have large thickness. This decreases the advantages of the smaller thickness.

In the case where a photoelectric conversion layer separately includes a layer consisting substantially of a p-type semiconductor and a layer consisting substantially of an n-type semiconductor, the dark current is suppressed to a low value. In this case, however, the photoelectric conversion efficiency is deteriorated. In the case of a bulk heterojunction structure in which a p-type semiconductor and an n-type semiconductor are contained in one photoelectric conversion layer, the structure has excellent photoelectric conversion efficiency but has a problem of the generation of dark current.

To deal with this problem, Non-Patent Literature 1 reports the relationship of the dark current to the difference in Ip between a hole-blocking layer and photoelectric conversion layer (quinacridone). In Non-Patent Literature 1, the presence of the blocking layer reduces the dark current density to about 1 × 10⁻⁷ A/cm².

As described in Patent Literature 1, a structure is also reported in which current-blocking layers (a hole-blocking layer and an electron-blocking layer) are disposed on both sides of a photoelectric conversion layer. The dark current density described in Patent Literature 1 is about 1 × 10⁻⁷ A/cm² at lowest and does not reach the level currently required.

The following description is made in paragraphs [0041] and [0042] of Patent Literature 2.

"An electron-blocking layer 5 has a lower HOMO energy level and a higher LUMO energy level than the p-type semiconductor layer 7 of a photoelectric conversion layer 3'. In other words, the photoelectric conversion layer 3' has a higher HOMO energy level than the electron-blocking layer and a lower LUMO energy level than the electron-blocking layer in the vicinity of the interface with the electron-blocking layer 5. The electron-blocking layer may also be composed of the above-mentioned p-type semiconductor or a hole transport organic compound.

A hole-blocking layer 6 is disposed to reduce the dark current due to holes injected from an upper electrode 4 and prevents the injection of the holes from the upper electrode 4 into the photoelectric conversion layer 3". It states that the hole-blocking layer is effective in reducing the dark current. Specific examples of the hole-blocking layer are described in Paragraph [0042]: "For the hole-blocking layer 6, organic substances, such as copper phthalocyanine, PTCDA, acetylacetonate complexes, BCP, and Alq, and metal-organic compounds, and inorganic substances, such as MgAg and MgO are preferably used".

Patent Literature 3 also discloses a structure in which a blocking layer is disposed on each side of a photoelectric conversion layer. However, Figs. 10A and 10B of Patent Literature 3 indicate that in Example 1, in which a p-type semiconductor and an n-type semiconductor are in the form of separate layers, although the value of the dark current is small, the efficiency is low and is only about 10% in the infrared region. In Examples 2 and 3, in which p- and n-type semiconductors are in the same layer, although the efficiency is good, the value of the dark current is very high and is about 1 × 10⁻⁵ A/cm² to about 1 × 10⁻⁶ A/cm² at -1 V.

As described above, in the related art, it is not possible to achieve both of high photoelectric conversion efficiency and a low dark current value.

### Patent Literature

PTL 1: JP2012-4578A
PTL 2: JP2016-134570A
PTL 3: JP2016-225456A

### Non Patent Literature

NPL 1: Journal of The Society of Photographic Science and Technology of Japan, 2008, volume 71, issue 2, pages 75-80

### Summary of Invention

The present invention aims to provide an organic photodiode having a low dark current value while maintaining high photoelectric conversion efficiency and an infrared CMOS sensor including the organic photodiode.

The inventors have succeeded in suppressing the dark current density to 10⁻⁷ A/cm² or less while maintaining relatively high photoelectric conversion efficiency by allowing a photoelectric conversion layer to have a bulk heterojunction structure containing a p-type semiconductor and an n-type semiconductor and by arranging a hole transport layer containing a specific polymer compound as a blocking layer.

That is, the gist of the present invention will be described below.
[1] An organic photodiode, comprising, in sequence:
   a first electrode, a hole transport layer, a photoelectric conversion layer, and a second electrode,
   wherein the photoelectric conversion layer contains a p-type semiconductor and an n-type semiconductor,
   the hole transport layer contains a polymer compound containing a repeat unit represented by formula (2) described below, and
   the polymer compound contains groups that form mutual bonds between carbon atoms of side chains of molecules of the polymer compound at 230°C. 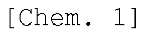 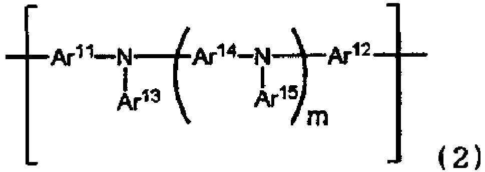
      In formula (2), m is an integer of 0 to 3.
      Ar¹¹ and Ar¹² are each independently a direct bond, an optionally substituted aromatic hydrocarbon group, or an optionally substituted heteroaromatic group.
      Ar¹³ to Ar¹⁵ are each independently an optionally substituted aromatic hydrocarbon group or an optionally substituted heteroaromatic group.
      m Ar¹⁴'s are optionally the same or different from each other, and m Ar¹⁵'s are optionally the same or different from each other.
      Ar¹¹ and Ar¹² are not both direct bonds.
[2] The organic photodiode according to [1], wherein the groups that form the mutual bonds between the carbon atoms of the side chains at 230°C are each a group represented by any of formulae (1A) to (1I), 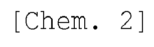 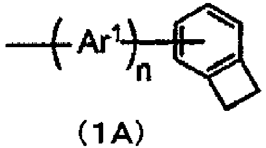 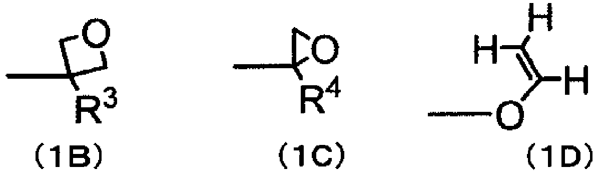 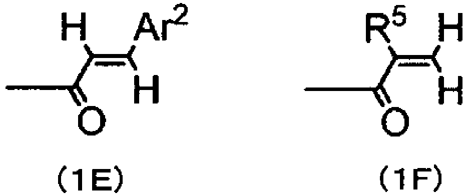 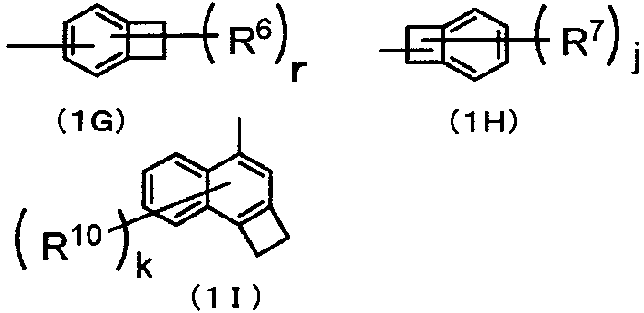
   In formula (1A), Ar¹ is an optionally substituted aromatic hydrocarbon group or an optionally substituted heteroaromatic group.
   n is an integer of 1 to 6.
   n Ar^{1'}s are optionally the same or different from each other, a benzocyclobutene ring in formula (1A) optionally contains one or more substituents, the one or more substituents are optionally taken together to form a ring.
   In formulae (1B) to (1I), R³ to R⁵ are each a hydrogen atom or an alkyl group.
   R⁶, R⁷, and R¹⁰ are each a hydrogen atom, an alkyl group, or an alkoxy group.
   r and j are each an integer of 1 to 5, k is an integer of 1 to 7.
   When r is 2 or more, multiple R^{6'}s are optionally the same or different from each other, adjacent R^{6'}s are optionally taken together to form a ring.
   When j is 2 or more, multiple R^{7'}s are optionally the same or different from each other, adjacent R^{7'}s are optionally taken together to form a ring.
   When k is 2 or more, multiple R^{10'}s are optionally the same or different from each other.
   Ar² is an optionally substituted aromatic hydrocarbon group or an optionally substituted heteroaromatic group.
[3] The organic photodiode according to [1] or [2], wherein the groups that form the mutual bonds between the carbon atoms of the side chains at 230°C are each a group that undergoes ring-opening polymerization.
[4] The organic photodiode according to any one of [1] to [3], wherein the n-type semiconductor is represented by formula (4) illustrated below: 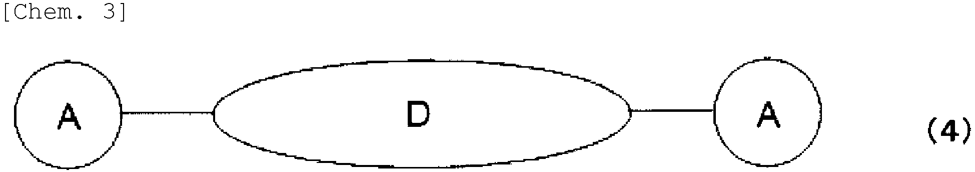
   In formula (4), D is a donor site containing an polycyclic aromatic moiety, and each A is an acceptor site containing a malononitrile group.
[5] The organic photodiode according to any one of [1] to [4], wherein the n-type semiconductor is represented by formula (5) illustrated below: 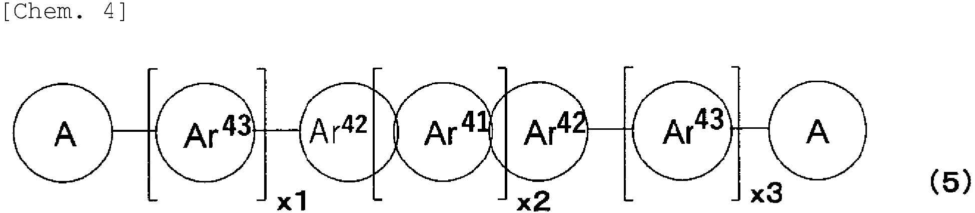
   In formula (5), each Ar⁴¹ is independently represented by any of formulae (5a-1) to (5g-1) illustrated below.
   Each Ar⁴² is independently represented by any of formulae (5a-2) to (5d-2) illustrated below.
   Each Ar⁴³ is independently represented by any of formulae (5a-3) to (5d-3) illustrated below. 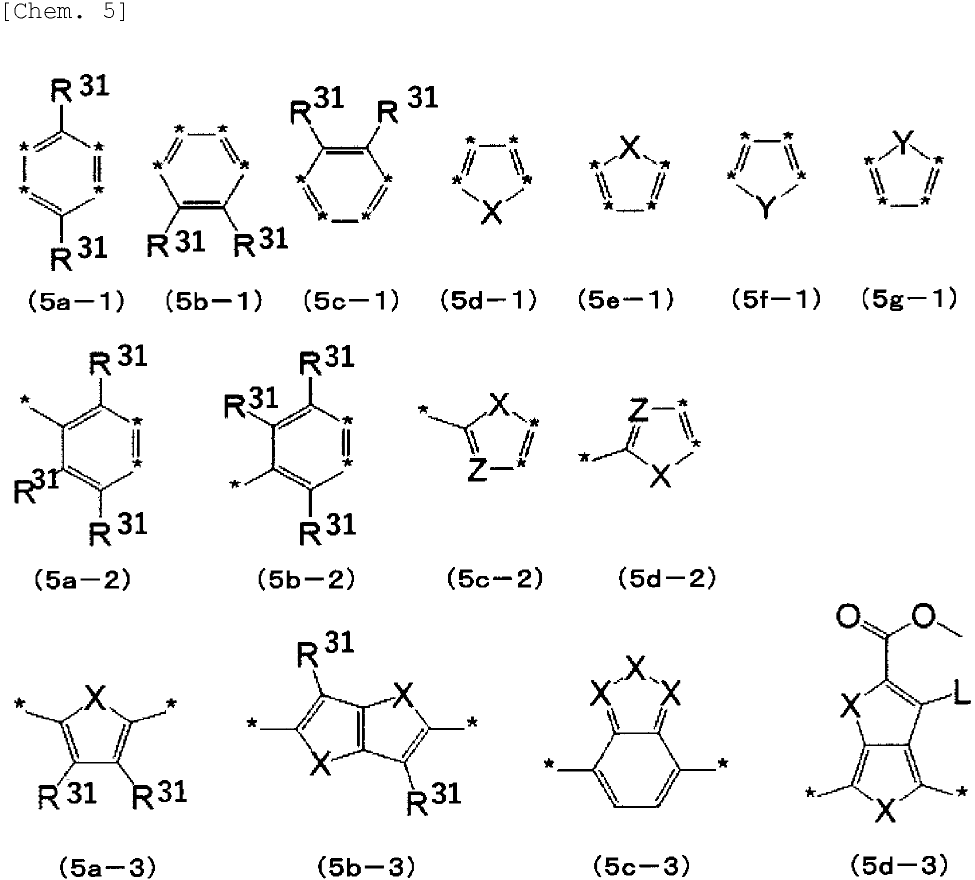
   In formulae (5a-1) to (5g-1), (5a-2) to (5d-2), and (5a-3) to (5d-3), each * is a binding site.
   Each X is C=O, O, S, or Se.
   Y is CR³¹R³¹, SiR³¹R³¹, GeR³¹R³¹, NR³¹, or C=O,
   each Z is CR³¹ or N.
   L is R³¹ or a halogen atom.
   Each R³¹ is independently a hydrogen atom, an optionally branched alkyl group having 1 to 30 carbon atoms, an optionally branched alkoxy group having 1 to 30 carbon atoms, or a phenyl group optionally substituted with an optionally branched alkyl group having 1 to 30 carbon atoms and/or an optionally branched alkoxy group having 1 to 30 carbon atoms.
   Each A is an acceptor site containing a malononitrile group.
   x1 is 0 or 1, x2 is an integer of 1 to 6, and x3 is 0 or 1.
   In formula (5), formulae (5f-1) and (5g-1) are not adjacent to each other.
[6] The organic photodiode according to [4] or [5], wherein each A that is the acceptor site containing the malononitrile group is represented by any of formulae (5A) to (5C) illustrated below: 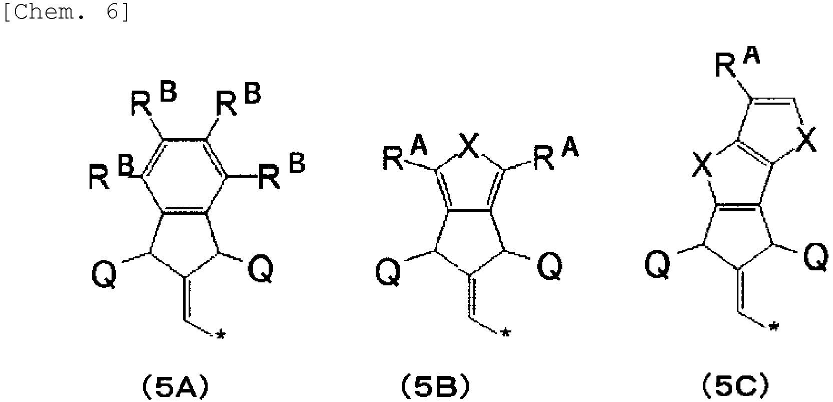
   In formulae (5A) to (5C), each * is a binding site.
   Each Q is a malononitrile group or 0=, at least one of Q's is a malononitrile group.
   Each X is C=O, O, S, or Se.
   Each R^{A} is independently a hydrogen atom, a halogen atom, an optionally branched alkyl group having 1 to 30 carbon atoms, an optionally branched alkoxy group having 1 to 30 carbon atoms, or a phenyl group optionally substituted with an optionally branched alkyl group having 1 to 30 carbon atoms and/or an optionally branched alkoxy group having 1 to 30 carbon atoms.
   Each R^{B} is defined the same as R^{A}, or adjacent R^{B'}s are taken together to form a six-membered aromatic ring.
[7] The organic photodiode according to any one of [1] to [6], wherein the polymer compound contains, as a partial structure, a monovalent or di- or higher valent group derived from a fluorene ring.
[8] The organic photodiode according to any one of [1] to [7], wherein the polymer compound has a weight-average molecular weight (Mw) of 20,000 or more and a polydispersity index (Mw/Mn) of 2.5 or less (where Mn is a number-average molecular weight).
[9] The organic photodiode according to any one of [1] to [8], wherein the polymer compound contains a repeat unit represented by formula (3) illustrated below, 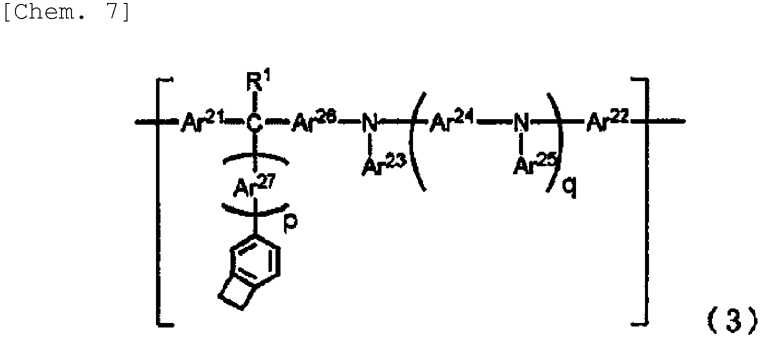
   In formula (3), p is an integer of 1 or more and 6 or less, q is an integer of 0 or more and 3 or less.
   Ar²¹ and Ar²² are each independently a direct bond, an optionally substituted aromatic hydrocarbon group, or an optionally substituted heteroaromatic group.
   Ar²³ to Ar²⁷ are each independently an optionally substituted aromatic hydrocarbon group or an optionally substituted heteroaromatic group.
   R¹ is a hydrogen atom, an optionally substituted alkyl group having 1 to 24 carbon atoms, an optionally substituted alkoxy group having 1 to 24 carbon atoms, an optionally substituted aromatic hydrocarbon group, or an optionally substituted heteroaromatic group.
   p Ar^{27'}s are optionally the same or different from each other. q Ar²⁴ are optionally the same or different from each other, and q Ar²⁵ are optionally the same or different from each other. Ar²¹ and Ar²² are not both direct bonds.
[10] The organic photodiode according to any one of [1] to [9], wherein the polymer compound contains 0.01 or more and 3 or less groups represented by formula (1) per molecular weight of 1,000.
[11] The organic photodiode according to any one of [1] to [10], wherein in the n-type semiconductor, the percentage of an n-type semiconductor having a fullerene skeleton is 10% or less by weight based on an n-type semiconductor having no fullerene skeleton.
[12] The organic photodiode according to any one of [1] to [11], wherein in the n-type semiconductor, substantially no n-type semiconductor having a fullerene skeleton is contained.
[13] An infrared CMOS sensor, comprising the organic photodiode according to any one of [1] to [12]. Advantageous Effects of Invention

According to the present invention, an organic photodiode having high photoelectric conversion efficiency and a low dark current value can be provided. A high-performance infrared CMOS sensor including the organic photodiode of the present invention can be provided.

### Brief Description of Drawings

[Fig. 1] Fig. 1 is a schematic cross-sectional view illustrating an organic photodiode according to an embodiment of the present invention.
[Fig. 2] Fig. 2 is a schematic cross-sectional view illustrating an example of the structure of an infrared CMOS sensor of the present invention including the organic photodiode of the present invention.

### Description of Embodiments

Best modes for carrying out the present invention will be described in detail below. The description of the constituent elements described below is a representative example of the embodiment of the present invention, and the present invention is not limited to these contents.

### [Organic Photodiode]

The organic photodiode of the present invention comprises, in sequence, a first electrode, a hole transport layer, a photoelectric conversion layer, and a second electrode, wherein the photoelectric conversion layer contains a p-type semiconductor and an n-type semiconductor, the hole transport layer contains a polymer compound containing a repeat unit represented by formula (2) described below, and the polymer compound contains groups that form mutual bonds between carbon atoms of side chains of molecules of the polymer compound at 230°C.

Hereinafter, the polymer compound that is contained in the hole transport layer according to the present invention, that contains the repeat unit represented by formula (2), and in which the polymer compound contains the groups that form the mutual bonds between the carbon atoms of the side chains at 230°C is referred to as a "hole transport polymer of the present invention", in some cases.

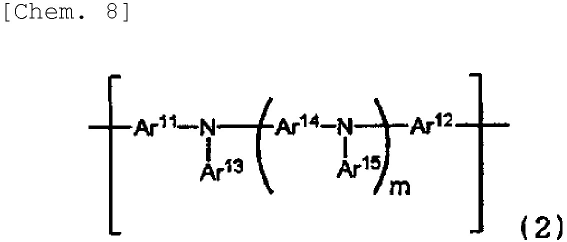

In formula (2), m is an integer of 0 to 3.

Ar¹¹ and Ar¹² are each independently a direct bond, an optionally substituted aromatic hydrocarbon group, or an optionally substituted heteroaromatic group.

Ar¹³ to Ar¹⁵ are each independently an optionally substituted aromatic hydrocarbon group or an optionally substituted heteroaromatic group.

m Ar¹⁴'s are optionally the same or different from each other, and m Ar¹⁵'s are optionally the same or different from each other.

Ar¹¹ and Ar¹² are not both direct bonds.

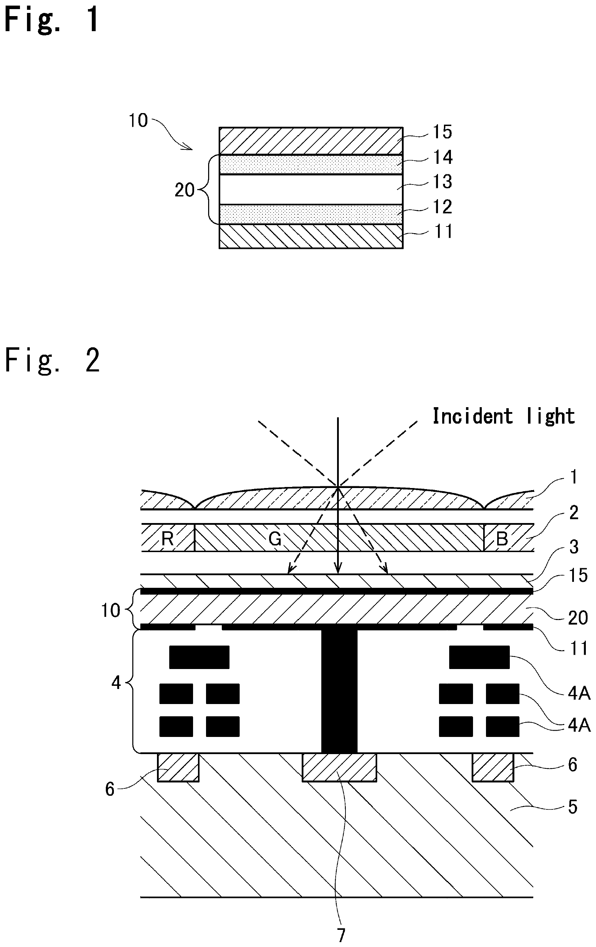

Fig. 1 is a schematic cross-sectional view illustrating an organic photodiode according to an embodiment of the present invention. An organic photodiode 10 includes a first electrode 11, a hole transport layer 12, a photoelectric conversion layer 13, an electron transport layer 14, and a second electrode 15 serving as an upper electrode stacked in that order. The hole transport layer 12, the photoelectric conversion layer 13, and the electron transport layer 14 form an organic photoelectric film 20. Usually, a substrate is provided on a side of the first electrode 11 opposite the side adjacent to the hole transport layer 12. In the case where the hole transport layer according to the present invention is disposed on the first electrode provided on the substrate, the smoothness of the substrate affects the hole transport layer side to obtain uniform layers, which is preferred.

### <Hole Transport Polymer>

The hole transport polymer of the present invention will be described below, in which the hole transport polymer is used for the hole transport layer of the organic photodiode of the present invention and is the polymer compound containing the repeat unit represented by formula (2) and containing the groups that form the mutual bonds between the carbon atoms of the side chains of the molecules of the polymer compound at 230°C (hereinafter, referred to simply as "groups that form the mutual bonds between the carbon atoms of the side chains at 230°C", in some cases).

Examples of the groups that are contained in the hole transport polymer of the present invention and that form the mutual bonds between the carbon atoms of the side chains at 230°C include, but are not particularly limited to, groups each having an aromatic hydrocarbon group between a main chain and a crosslinkable group and groups represented by formulae (1A) to (1I), because it is desirable that main chains be appropriately spaced apart from each other after polymerization in order to prevent aggregation.

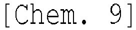

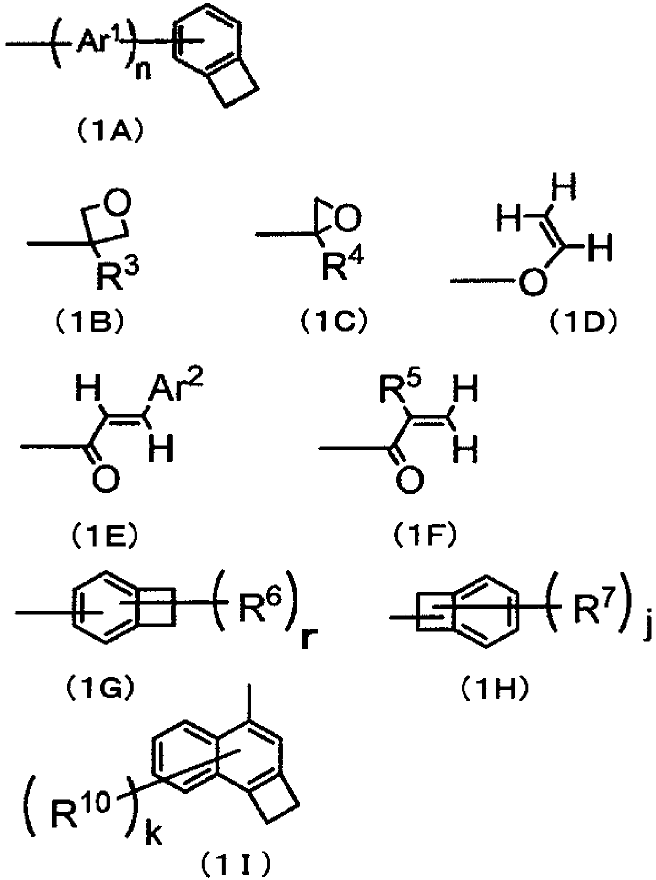

In formula (1A), each Ar¹ is an optionally substituted aromatic hydrocarbon group or an optionally substituted heteroaromatic group.

n is an integer of 1 to 6.

n Ar^{1'}s may be the same or different from each other. The benzocyclobutene ring in formula (1A) may contain one or more substituents. The substituents may be taken together to form a ring.

In formulae (1B) to (11), R³ to R⁵ are each a hydrogen atom or an alkyl group.

R⁶, R⁷, and R¹⁰ are each a hydrogen atom, an alkyl group, or an alkoxy group.

r and j are each an integer of 1 to 5, and k is an integer of 1 to 7.

When r is 2 or more, multiple R^{6'}s may be the same or different from each other, and adjacent R^{6'}s may be taken together to form a ring.

When j is 2 or more, multiple R^{7'}s may be the same or different from each other, and adjacent R^{7'}s may be taken together to form a ring.

When k is 2 or more, multiple R^{10'}s may be the same or different from each other.

Ar² is an optionally substituted aromatic hydrocarbon group or an optionally substituted heteroaromatic group.

Regarding the expression "the groups that form the mutual bonds between the carbon atoms of the side chains at 230°C", the hole transport polymer of the present invention is polymerized at 230°C, which is a temperature at which ring-opening polymerization is performed, and thus is insolubilized. This leads to the fact that stacking a layer by coating in the subsequent process can be performed, which is effective in employing a coating process. In this sense, groups that can form the mutual bonds between the carbon atoms of the side chains at 200°C, which is a lower temperature, are more preferred.

In the present invention, whether there are the groups that form the mutual bonds between the carbon atoms of the side chains at 230°C can be easily determined by a person skilled in the art on the basis of the type of group. When a difficulty lies in the determination from the entire structure, it can be determined as described below.

An appropriate amount of the polymer compound is dissolved in toluene. The resulting solution is applied to a base material and then dried by heating at 230°C for 1 hour to form a film having a thickness of 25 nm to 100 nm. It can be determined by the fact that the resulting film is substantially not dissolved even if it is held in toluene at normal temperature. In this case, the fact that the film is substantially not dissolved in toluene and thus is little reduced in thickness may be checked by cross-sectional observation with a SEM.

The groups that are contained in the hole transport polymer of the present invention and that form the mutual bonds between the carbon atoms of the side chains at 230°C are each preferably a group such that, in particular, the polymer compound undergoes ring-opening polymerization, from the viewpoint of achieving insolubilization and performing stacking by coating in the subsequent process. Accordingly, the groups are each preferably a group represented by any of formulae (1A) to (1I) illustrated above, more preferably a group represented by any of formulae (1A), (1G), (1H), and (1I) each containing a cyclobutene group.

### [1. Hole Transport Polymer Containing Group Represented by Formula (1A)]

Regarding a representative example of the hole transport polymer of the present invention, the group represented by formula (1A) of a hole transport polymer that contains the group represented by formula (1A) and the repeat unit represented by formula (2) (hereinafter, referred to as a "hole transport polymer (1A) of the present invention", in some cases) will be described.

In the hole transport polymer (1A) of the present invention, a benzocyclobutene ring is coupled to a carbon atom in the main chain with Ar¹, which is one to six aromatic hydrocarbon groups or heteroaromatic groups, provided therebetween.

In the hole transport polymer (1A) of the present invention, since one to six aromatic hydrocarbon groups or heteroaromatic groups are present between the main chain and the crosslinkable group, the main chains are appropriately spaced apart from each other; thus, for example, aggregation does not occur, and hole transfer is promoted between the crosslinked main chains. Additionally, excellent heat resistance is obtained because of the rigid structure between the main chain and the crosslinkable group.

In the hole transport polymer (1A) of the present invention, the benzocyclobutene ring is preferably coupled to a carbon atom that is present in the main chain and that is the center of sp³ hybrid orbitals with one to six aromatic hydrocarbon groups or heteroaromatic groups provided therebetween.

The carbon atom that is the center of the sp³ hybrid orbitals is not involved in a *π*-conjugated system. The crosslinkable group that serves as the side chain coupled to the carbon atom that is the center of the sp³ hybrid orbitals is less likely to impede the transport of holes. Thus, the hole transport polymer and a network polymer obtained by crosslinking the hole transport polymer have improved hole transport properties.

Furthermore, bonds around an atom at the center of sp³ hybrid orbitals in the polymer main chain are prone to rotation, compared with an atom at the center of sp² hybrid orbitals. Thus, the crosslinkable groups in the hole transport polymer react efficiently. Accordingly, even at a small number of crosslinkable groups or even under mild crosslinking reaction conditions, the polymer can be made poorly soluble in an organic solvent.

Examples of a substituent that may be present on the benzocyclobutene ring in formula (1A) in addition to Ar¹ include those given in Section [Substituent Group Z] below. Preferably, the benzocyclobutene ring in formula (1A) has no substituent other than Ar¹ in view of the steric hindrance of the substituent and a small electronic effect of the substituent on the crosslinking reaction.

### [1-1. Ar¹]

Ar¹ is an optionally substituted aromatic hydrocarbon group or an optionally substituted heteroaromatic group.

Examples of the aromatic hydrocarbon group denoted by Ar¹ include mono- or higher-valent, six-membered monocyclic or fused bicyclic to pentacyclic ring groups, such as a benzene ring, a naphthalene ring, an anthracene ring, a phenanthrene ring, a perylene ring, a tetracene ring, a pyrene ring, a benzpyrene ring, a chrysene ring, a triphenylene ring, an acenaphthene ring, a fluoranthene ring, and a fluorene ring.

Examples of the heteroaromatic group denoted by Ar¹ include mono- or higher-valent, five- or six-membered monocyclic or fused bicyclic to tetracyclic ring groups, such as a furan ring, a benzofuran ring, a thiophene ring, a benzothiophene ring, a pyrrole ring, a pyrazole ring, an imidazole ring, an oxadiazole ring, an indole ring, a carbazole ring, a pyrroloimidazole ring, a pyrrolopyrazole ring, a pyrrolopyrrole ring, a thienopyrrole ring, a thienothiophene ring, a furopyrrole ring, a furofuran ring, a thienofuran ring, a benzisoxazole ring, a benzisothiazole ring, a benzimidazole ring, a pyridine ring, a pyrazine ring, a pyridazine ring, a pyrimidine ring, a triazine ring, a quinoline ring, an isoquinoline ring, a cinnoline ring, a quinoxaline ring, a phenanthridine ring, a benzimidazole ring, a perimidine ring, a quinazoline ring, a quinazolinone ring, and an azulene ring.

Ar¹ is preferably a group derived from a ring selected from the group consisting of a benzene ring, a naphthalene ring, an anthracene ring, and a phenanthrene ring, most preferably a group derived from a benzene ring, that is, a phenylene group, in view of excellent hole transport properties and excellent durability.

Examples of a substituent that may be present on the aromatic hydrocarbon group or the heteroaromatic group denoted by Ar¹ include, but are not particularly limited to, groups selected from substituent group Z described below. This substituent is preferably an alkyl group, an alkoxy group, an aromatic hydrocarbon group, or a heteroaromatic group.

The number of carbon atoms in Ar¹ including substituents is usually 3 or more, preferably 5 or more, more preferably 6 or more, and usually 36 or less, preferably 24 or less, more preferably 12 or less, from the viewpoint of achieving excellent hole transport properties and excellent durability.

### [Substituent Group Z]

Examples thereof include linear, branched, and cyclic alkyl groups having usually 1 or more and usually 24 or less, preferably 12 or less carbon atoms, such as a methyl group, an ethyl group, a n-propyl group, an i-propyl group, a n-butyl group, an i-butyl group, a sec-butyl group, a tert-butyl group, a n-hexyl group, a cyclohexyl group, and a dodecyl group;
alkenyl groups having usually 2 or more and usually 24 or less, preferably 12 or less carbon atoms, such as a vinyl group;
alkynyl groups having usually 2 or more and usually 24 or less, preferably 12 or less carbon atoms, such as an ethynyl group;
alkoxy groups having usually 1 or more and usually 24 or less, preferably 12 or less carbon atoms, such as a methoxy group and an ethoxy group;
aryloxy groups having usually 4 or more, preferably 5 or more, and usually 36 or less, preferably 24 or less carbon atoms, such as a phenoxy group, a naphthoxy group, and a pyridyloxy group;
alkoxycarbonyl groups having usually 2 or more and usually 24 or less, preferably 12 or less carbon atoms, such as a methoxycarbonyl group and an ethoxycarbonyl group;
dialkylamino groups having usually 2 or more and usually 24 or less, preferably 12 or less carbon atoms, such as a dimethylamino group and a diethylamino group;
diarylamino groups having usually 10 or more, preferably 12 or more, and usually 36 or less, preferably 24 or less carbon atoms, such as a diphenylamino group, a ditolylamino group, and an N-carbazolyl group;
arylalkylamino groups having usually 7 or more and usually 36 or less, preferably 24 or less carbon atoms, such as a phenylmethylamino group;
acyl groups having usually 2 or more and usually 24 or less, preferably 12 or less carbon atoms, such as an acetyl group and a benzoyl group;
halogen atoms, such as a fluorine atom and a chlorine atom;
haloalkyl groups having usually 1 or more and usually 12 or less, preferably 6 or less carbon atoms, such as a trifluoromethyl group;
alkylthio groups having usually 1 or more and usually 24 or less, preferably 12 or less carbon atoms, such as a methylthio group and an ethylthio group;
arylthio groups having usually 4 or more, preferably 5 or more, and usually 36 or less, preferably 24 or less carbon atoms, such as a phenylthio group, a naphthylthio group, and a pyridylthio group;
silyl groups having usually 2 or more, preferably 3 or more, and usually 36 or less, preferably 24 or less carbon atoms, such as a trimethylsilyl group and a triphenylsilyl group;
siloxy groups having usually 2 or more, preferably 3 or more, and usually 36 or less, preferably 24 or less carbon atoms, such as a trimethylsiloxy group and a triphenylsiloxy group;
a cyano group;
aromatic hydrocarbon groups having usually 6 or more and usually 36 or less, preferably 24 or less carbon atoms, such as a phenyl group and a naphthyl group; and
heteroaromatic groups having usually 3 or more, preferably 4 or more, and usually 36 or less, preferably 24 or less carbon atoms, such as a thienyl group and a pyridyl group.

Among these substituent groups Z described above, an alkyl group having 1 to 12 carbon atoms and an alkoxy group having 1 to 12 carbon atoms are preferred in view of solubility.

Each of the substituents described above may further have a substituent. Examples thereof are selected from the groups given in Section "Substituent Group Z".

### [1-2. n]

n is an integer of 1 or more and 6 or less. n is preferably an integer of 1 or more and 3 or less in view of the fact that the crosslinking reaction proceeds easily and excellent hole transport properties are provided after the crosslinking reaction without the aggregation of the main chains or an excessive space therebetween. When n is 2 or more, n Ar^{1'}s may be the same or different.

### [2. Groups Represented by Formulae (1B) to (1I)]

The hole transport polymer of the present invention may contain a group represented by any of formulae (1B) to (1I) in place of the group represented by formula (1A) or may contain the group represented by formula (1A) and the group represented by any of formulae (1B) to (1I).

An alkyl group denoted by each of R³ to R⁷ and R¹⁰ in formulae (1B), (1C), and (1F) to (1I) is preferably a linear or branched chain alkyl group usually having 6 or less carbon atoms, for example, a methyl group, an ethyl group, a n-propyl group, a 2-propyl group, a n-butyl group, or an isobutyl group, more preferably a methyl group or an ethyl group. When each of R³ to R⁷ and R¹⁰ has 6 or less carbon atoms, the crosslinking reaction is not sterically hindered, and the insolubilization of the film to be formed tends to occur.

An alkoxy group denoted by each of R⁶, R⁷, and R¹⁰ is preferably a linear or branched chain alkoxy group usually having 6 or less carbon atoms, for example, a methoxy group, an ethoxy group, a n-propoxy group, a 2-propoxy group, or a n-butoxy group, more preferably a methoxy group or an ethoxy group. When each of R⁶, R⁷, and R¹⁰ has 6 or less carbon atoms, the crosslinking reaction is not sterically hindered, and the insolubilization of the film to be formed tends to occur.

Examples of an optionally substituted aromatic hydrocarbon group denoted by Ar² in formula (1E) include six-membered monocyclic or fused bicyclic to pentacyclic rings having a free valence of 1, such as a benzene ring and a naphthalene ring. In particular, a benzene ring having a free valence of 1 is preferred. Ar² may also be a group in which two or more optionally substituted aromatic hydrocarbon groups are bonded together. Examples of the group include a biphenylene group and a terphenylene group. Preferred is a 4,4'-biphenylene group.

Substituents that may be present on Ar² are the same as those given in "Substituent Group Z".

Among the crosslinkable groups illustrated in formulae (1A) to (1I), groups that undergo a crosslinking reaction by cationic polymerization, such as cyclic ethers, e.g., an epoxy group and an oxetane group, and vinyl ethers, are preferred because of their high reactivity and easy insolubilization by crosslinking. Of these, an oxetane group is more preferred from the viewpoint of easily controlling the rate of cationic polymerization. A vinyl ether is preferred because a hydroxy group, which may lead to the deterioration of the element during cationic polymerization, is less likely to be form.

Groups that undergo a cycloaddition reaction, such as an arylvinylcarbonyl group, e.g., a cinnamoyl group, a benzocyclobutene ring having a free valence of 1, and a 1,2-dihydrocyclobuta[a]naphthalene ring having a free valence of 1, are preferred from the viewpoint of further improving the electrochemical stability of the element.

Among these crosslinkable groups, a cyclobutene ring fused with an aromatic ring having a free valence of 1 and a group containing 1,2-dihydrocyclobuta[a]naphthalene ring having a free valence of 1 are preferred from the viewpoint of achieving a particularly stable crosslinked structure. Of these, a benzocyclobutene ring and a 1,2-dihydrocyclobuta[a]naphthalene ring having a free valence of 1 are more preferred. A 1,2-dihydrocyclobuta[a]naphthalene ring having a free valence of 1 is particularly preferred in view of a low crosslinking reaction temperature.

### [3. Repeat Unit Represented by Formula (2)]

The hole transport polymer of the present invention contains the repeat unit represented by formula (2). The hole transport polymer of the present invention has a main chain having an amine structure and a nitrogen atom that is the center of sp³ hybrid orbitals and thus is excellent in hole transport properties and electrical endurance.

### [3-1. Ar¹¹ to Ar¹⁵]

In formula (2), Ar¹¹ and Ar¹² are each independently a direct bond, an optionally substituted aromatic hydrocarbon group, or an optionally substituted heteroaromatic group, provided that Ar¹¹ and Ar¹² are not both direct bonds. Ar¹³ to Ar¹⁵ are each independently an optionally substituted aromatic hydrocarbon group or an optionally substituted heteroaromatic group.

Examples of the optionally substituted aromatic hydrocarbon groups denoted by Ar¹¹ to Ar¹⁵ include groups derived from six-membered monocyclic or fused bicyclic to pentacyclic rings, such as a benzene ring, a naphthalene ring, an anthracene ring, a phenanthrene ring, a perylene ring, a tetracene ring, a pyrene ring, a benzpyrene ring, a chrysene ring, a triphenylene ring, an acenaphthene ring, a fluoranthene ring, and a fluorene ring.

Examples of the optionally substituted heteroaromatic groups denoted by Ar¹¹ to Ar¹⁵ include groups derived from five- or six-membered monocyclic or fused bicyclic to tetracyclic rings, such as a furan ring, a benzofuran ring, a thiophene ring, a benzothiophene ring, a pyrrole ring, a pyrazole ring, an imidazole ring, an oxadiazole ring, an indole ring, a carbazole ring, a pyrroloimidazole ring, a pyrrolopyrazole ring, a pyrrolopyrrole ring, a thienopyrrole ring, a thienothiophene ring, a furopyrrole ring, a furofuran ring, a thienofuran ring, a benzisoxazole ring, a benzisothiazole ring, a benzimidazole ring, a pyridine ring, a pyrazine ring, a pyridazine ring, a pyrimidine ring, a triazine ring, a quinoline ring, an isoquinoline ring, a cinnoline ring, a quinoxaline ring, a phenanthridine ring, a benzimidazole ring, a perimidine ring, a quinazoline ring, a quinazolinone ring, and an azulene ring.

Preferably, Ar¹¹ to Ar¹⁵ are each independently a group derived from a ring selected from the group consisting of a benzene ring, a naphthalene ring, an anthracene ring, a phenanthrene ring, a triphenylene ring, a pyrene ring, a thiophene ring, a pyridine ring, and a fluorene ring, in view of solubility in a solvent and heat resistance.

Each of Ar¹¹ to Ar¹⁵ is also preferably a group in which one or two or more rings selected from the above-mentioned group are linked by a direct bond, more preferably a biphenyl group, a biphenylene group, a terphenyl group, and a terphenylene group.

Examples of the optionally substituted aromatic hydrocarbon group and the optionally substituted heteroaromatic group include the groups given in "Substituent Group Z" described above.

The number of carbon atoms in each of Ar¹¹ to Ar¹⁵ including substituents usually is usually 3 or more, preferably 5 or more, more preferably 6 or more, and usually 72 or less, preferably 48 or less, more preferably 25 or less, from the viewpoint of achieving excellent hole transport properties.

### [3-2. m]

In formula (2), m is an integer of 0 or more and 3 or less.

From the viewpoint of enhancing the solubility of the crosslinkable polymer in an organic solvent and film formability, m is preferably 0. From the viewpoint of improving the hole transport properties of the polymer, m is preferably 1 or more and 3 or less.

When m is 2 or more, the repeat unit represented by formula (2) contains two or more Ar¹⁴ and Ar¹⁵. In this case, Ar¹⁴'s may be the same or different from each other, and Ar¹⁵'s may be the same or different from each other. Ar^{14'} s may be taken together directly or with a linking group to form a ring structure. Ar¹⁵'s may be taken together directly or with a linking group to form a ring structure.

### [4. Repeat Unit Represented by Formula (3)]

The hole transport polymer of the present invention preferably contains a repeat unit represented by formula (3) illustrated below from the viewpoint of achieving excellent hole transport properties and excellent electrical endurance.

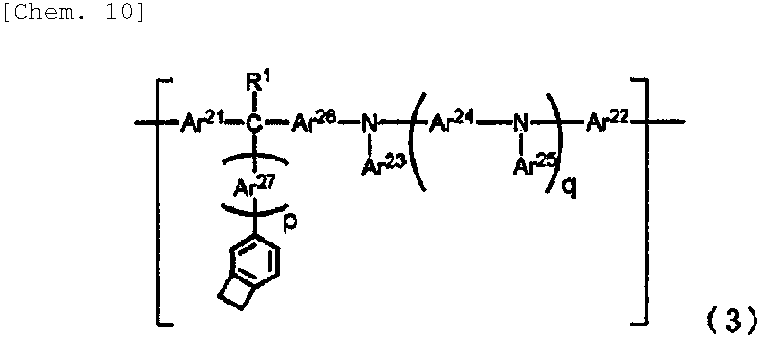

In formula (3), p is an integer of 1 or more and 6 or less, and q is an integer of 0 or more and 3 or less.

Ar²¹ and Ar²² are each independently a direct bond, an optionally substituted aromatic hydrocarbon group, or an optionally substituted heteroaromatic group.

Ar²³ to Ar²⁷ are each independently an optionally substituted aromatic hydrocarbon group or an optionally substituted heteroaromatic group.

R¹ is a hydrogen atom, an optionally substituted alkyl group having 1 to 24 carbon atoms, an optionally substituted alkoxy group having 1 to 24 carbon atoms, an optionally substituted aromatic hydrocarbon group, or an optionally substituted heteroaromatic group.

p Ar^{27'}s may be the same or different from each other. q Ar^{24'} s may be the same or different from each other. q Ar^{25'} s may be the same or different from each other. Ar²¹ and Ar²² are not both direct bonds.

### [4-1. Ar²¹ to Ar²⁶ and q]

In formula (3), Ar²¹ and Ar²² are each independently a direct bond, an optionally substituted aromatic hydrocarbon group, or an optionally substituted heteroaromatic group. Ar²¹ and Ar²² are not both direct bonds.

Ar²³ to Ar²⁶ are each independently an optionally substituted aromatic hydrocarbon group or an optionally substituted heteroaromatic group.

Specific examples and preferred examples of Ar²¹ to Ar²⁶ are the same as those of Ar¹¹ to Ar¹⁵ described above.

In formula (3), q is an integer of 0 or more and 3 or less. From the viewpoint of enhancing the solubility of the polymer in an organic solvent and film formability, q is preferably 0. From the viewpoint of improving the hole transport properties of the polymer, q is preferably 1 or more and 3 or less.

When q is 2 or more, the repeat unit represented by formula (3) contains two or more Ar²⁴ and Ar²⁵. In this case, Ar^{24'}s may be the same or different from each other, and Ar^{25'} s may be the same or different from each other. Ar^{24'}s may be taken together directly or with a linking group to form a ring structure. Ar^{25'} s may be taken together directly or with a linking group to form a ring structure.

### [4-2. Ar²⁷ and p]

In formula (3), (Ar²⁷)p is a group bonded to the carbon atom that is the center of the sp³ hybrid orbitals and to the benzocyclobutene ring, and is (Ar¹)n in formula (1A). Ar²⁷ is an optionally substituted aromatic hydrocarbon group or an optionally substituted heteroaromatic group. p is an integer of 0 or more and 6 or less. p Ar^{27'}s may be the same or different. Specific examples and preferred examples of Ar²⁷ are the same as those of Ar¹ described above.

### [4-3. R¹]

R¹ is a hydrogen atom, an optionally substituted alkyl group having 1 to 24 carbon atoms, an optionally substituted alkoxy group having 1 to 24 carbon atoms, an optionally substituted aromatic hydrocarbon group, or an optionally substituted heteroaromatic group. Among these, an alkyl group is preferred from the viewpoint of achieving excellent hole transport properties and high solubility before a crosslinking reaction.

The alkyl group is preferably a group usually having 1 or more and usually 24 or less, preferably 12 or less carbon atoms, such as a methyl group, an ethyl group, a n-propyl group, an i-propyl group, a n-butyl group, an i-butyl group, a sec-butyl group, a tert-butyl group, a n-hexyl group, a cyclohexyl group, or a dodecyl group. The alkoxy group is preferably a group usually having 1 or more and usually 24 or less, preferably 12 or less carbon atoms, such as a methoxy group or an ethoxy group. Examples of a substituent that may be present include the groups selected from the above-mentioned substituent group Z. Preferred are an alkyl group, an alkoxy group, an aromatic hydrocarbon group, and a heteroaromatic group.

Specific examples and preferred examples in the cases of the optionally substituted aromatic hydrocarbon group and the optionally substituted heteroaromatic group are the same as those of Ar¹¹ to Ar¹⁵ described above.

### [5. Preferred Partial Structure]

The hole transport polymer of the present invention preferably contains, as a partial structure, a monovalent or di- or higher valent group derived from a fluorene ring from the viewpoint of achieving excellent hole transport properties and excellent solubility before a crosslinking reaction.

### [6. Number of Groups, such as Group Represented by any of Formulae (1A) to (1I), That Form Mutual Bonds Between Carbon Atoms of Side Chains at 230°C]

In the present invention, the number of the groups that are possessed by the hole transport polymer of the present invention and that form the mutual bonds between the carbon atoms of the side chains at 230°C, each of the groups being preferably represented by any of formulae (1A) ∼ (1I), is expressed in terms of the number of the groups per molecular weight of 1,000. The number of the groups, such as groups each represented by any of formulae (1A) to (1I), that form the mutual bonds between the carbon atoms of the side chains at 230°C, per molecular weight of 1,000 of the hole transport polymer (hereinafter, referred to as "formula (1) number/1,000", in some cases) can be calculated from the ratio by mole of monomers fed for the synthesis of the hole transport polymer from which the end groups have been excluded and the structural formula.

For example, this will be described in the case of a polymer (H1) represented by formula (H1) used in Example 2 described below. In the polymer (H1), the molecular weight excluding the end groups is 503.42. The average number of the groups represented by formula (1A) is 0.05 per molecule. When this is calculated by simple proportion, the number of the groups represented by formula (1A) per molecular weight of 1,000 is calculated to be 0.1.

The number of groups possessed by the hole transport polymer of the present invention and represented by any of formulae (1A) to (1I) is usually 3.0 or less, preferably 2.0 or less, more preferably 1.0 or less and usually 0.01 or more, preferably 0.05 or more, per molecular weight 1,000.

When formula (1) number/1,000 is more than the upper limit described above, a flat film may fail to be formed because of cracking. Additionally, the crosslink density may increase excessively to increase the number of unreacted groups represented by any of formulae (1A) ∼ (1I) in the crosslinked layer, thereby possibly affecting the lifetime of an organic photodiode to be obtained. When formula (1) number/1,000 is lower than the lower limit, the crosslinked layer may be insufficiently insolubilized to fail to form a multilayer stack structure by a wet film formation process.

### [7. Preferred Molecular Distribution]

The hole transport polymer of the present invention preferably has a weight-average molecular weight (Mw) of 20,000 or more, more preferably 60,000 or more from the viewpoint of achieving excellent hole transport properties and easily making the polymer poorly soluble in an organic solvent after a crosslinking reaction. The upper limit of the weight-average molecular weight (Mw) is usually 500,000 or less, preferably 200,000 or less in view of a decrease in the filterability of a hole transport layer formation composition described below and a difficulty that lies in the formation of a thin film because of excessively high viscosity of the hole transport layer formation composition.

The hole transport polymer of the present invention preferably has a polydispersity index (Mw/Mn) of 2.5 or less, more preferably 2.0 or less from the viewpoint of achieving excellent hole transport properties and easily making the polymer poorly soluble in an organic solvent after a crosslinking reaction.

The weight-average molecular weight (Mw) and the polydispersity index (Mw/Mn) are determined by size exclusion chromatography (SEC) measurement. In the SEC measurement, a higher-molecular-weight component results in a shorter elution time, and a lower-molecular-weight component results in a longer elution time. The weight-average molecular weight is calculated by converting the elution time of a sample into a molecular weight using a calibration curve obtained through calculation from the elution times of polystyrene samples (standard samples) having known molecular weights.

### [8. Specific Example]

Preferred examples of the repeat unit of the hole transport polymer (1A) of the present invention are illustrated below. The repeat unit of the hole transport polymer of the present invention is not limited to these examples.

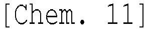

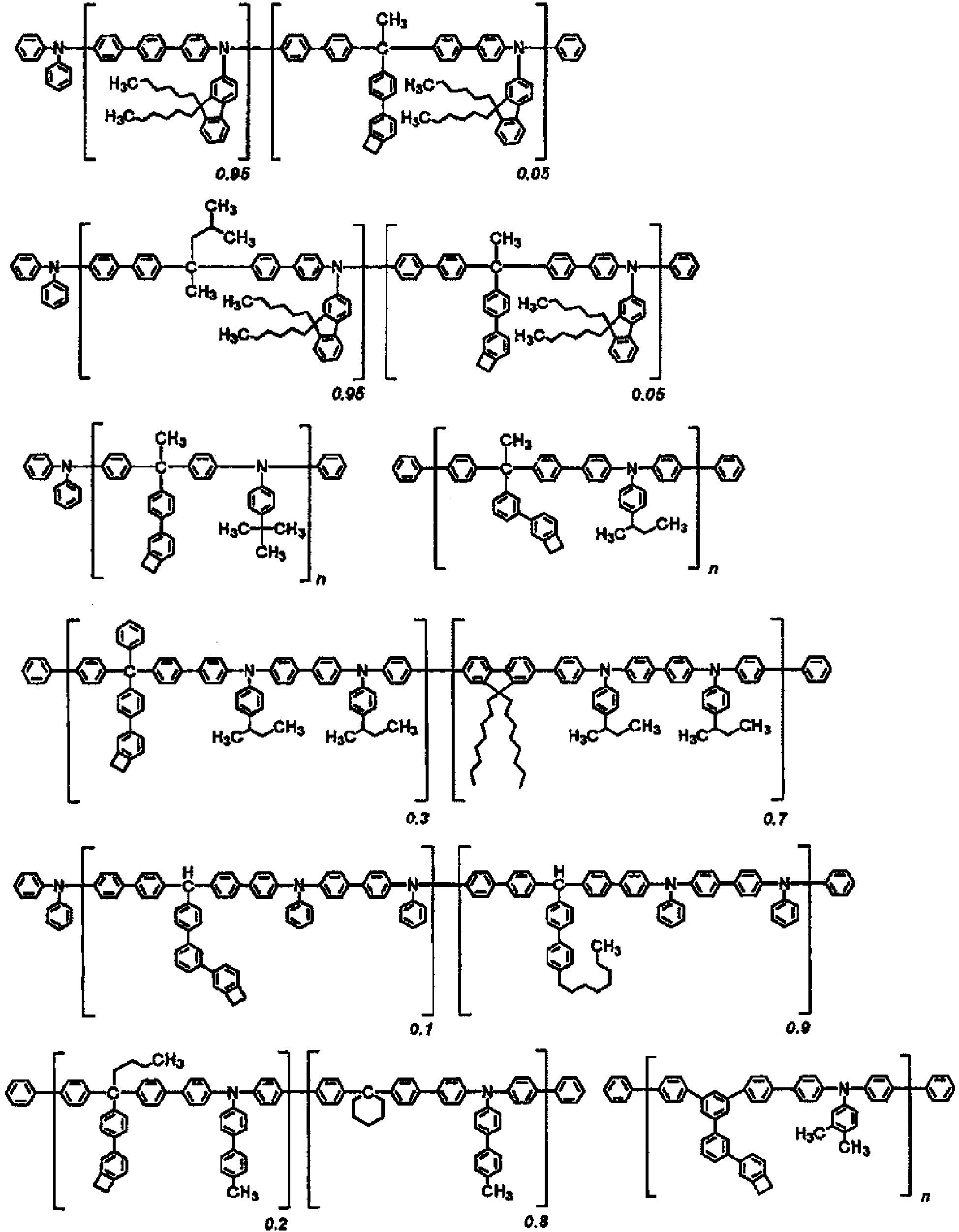

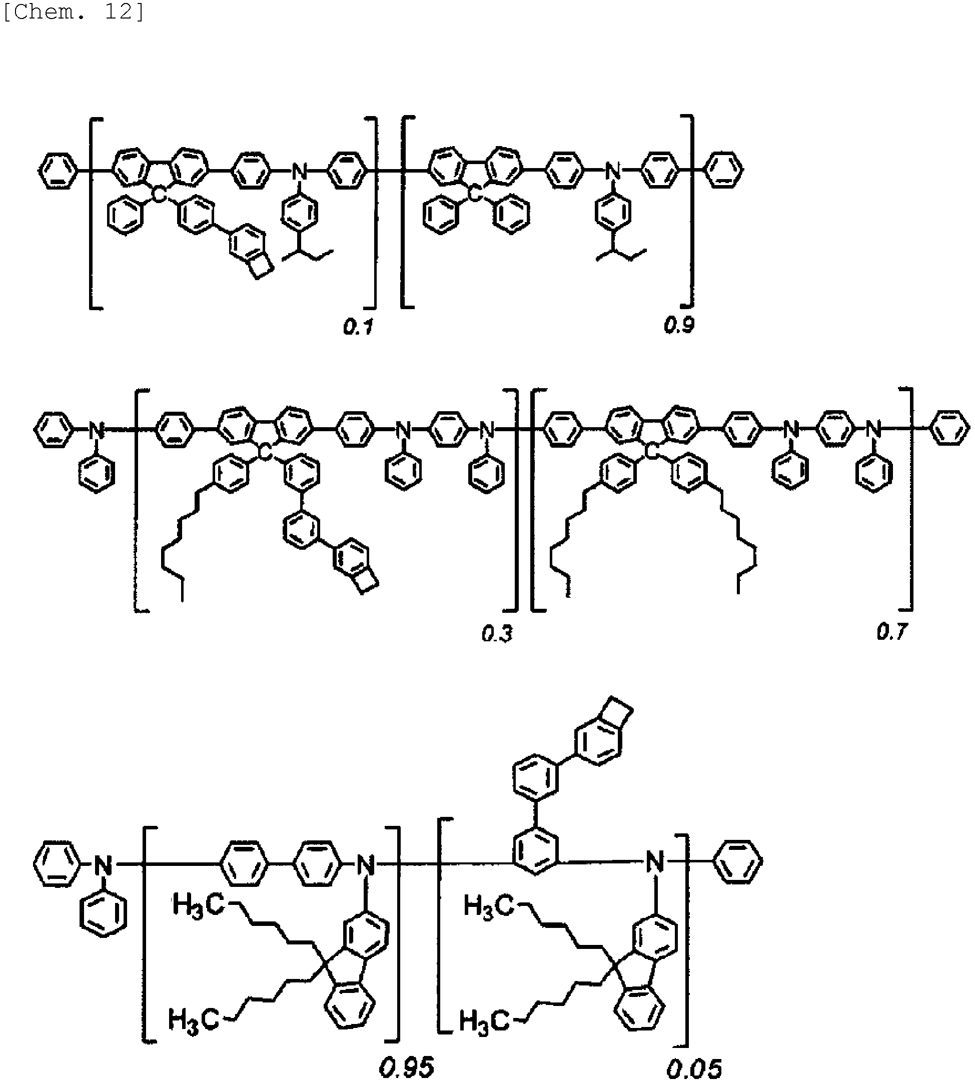

### [9. Synthesis Method]

The hole transport polymer of the present invention can be synthesized by selecting raw materials in accordance with the structure of a target compound and using a known method.

A known coupling method can be employed as a method for synthesizing a monomer containing a group represented by formula (1A). For example, the monomer is synthesized by the Suzuki reaction as illustrated in reaction formulae below.

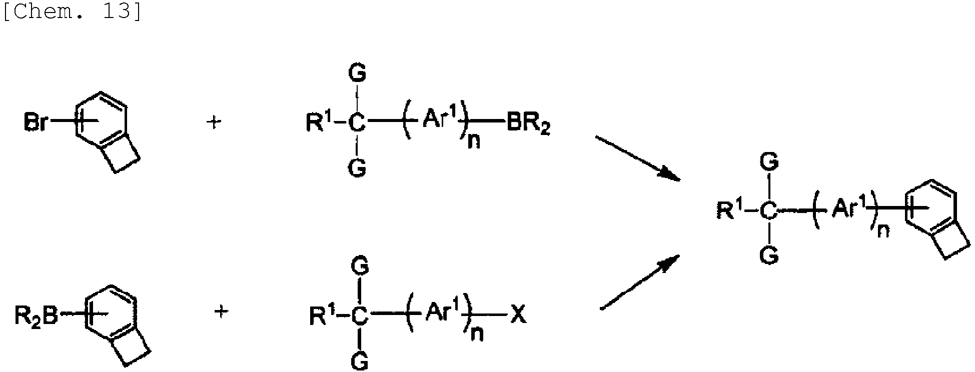

In the above-mentioned reaction formulae, each G is a group that reacts during polymerization. Each BR₂ is a boronic acid group or a boronic ester group. Each R¹ is a hydrogen atom, an optionally substituted alkyl group having 1 to 24 carbon atoms, an optionally substituted alkoxy group having 1 to 24 carbon atoms, an optionally substituted aromatic hydrocarbon group, or an optionally substituted heteroaromatic group. Ar¹ is an optionally substituted aromatic hydrocarbon group or an optionally substituted heteroaromatic group. n is an integer of 1 to 6. n Ar^{1'}s may be the same or different.

A method for producing the hole transport polymer of the present invention is not particularly limited, and any method can be employed as long as the hole transport polymer of the present invention is produced. The polymer can be produced by, for example, a polymerization method using the Suzuki reaction, a polymerization method using the Grignard reaction, a polymerization method using the Yamamoto reaction, a polymerization method using the Ullmann reaction, or a polymerization method using the Buchwald-Hartwig reaction.

In the cases of the polymerization method using the Ullmann reaction and the polymerization method using the Buchwald-Hartwig reaction, for example, aryl dihalides represented by formulae 1a and 2a and a primary arylamine or secondary arylamine represented by formula 3a are reacted to synthesize the hole transport polymer of the present invention.

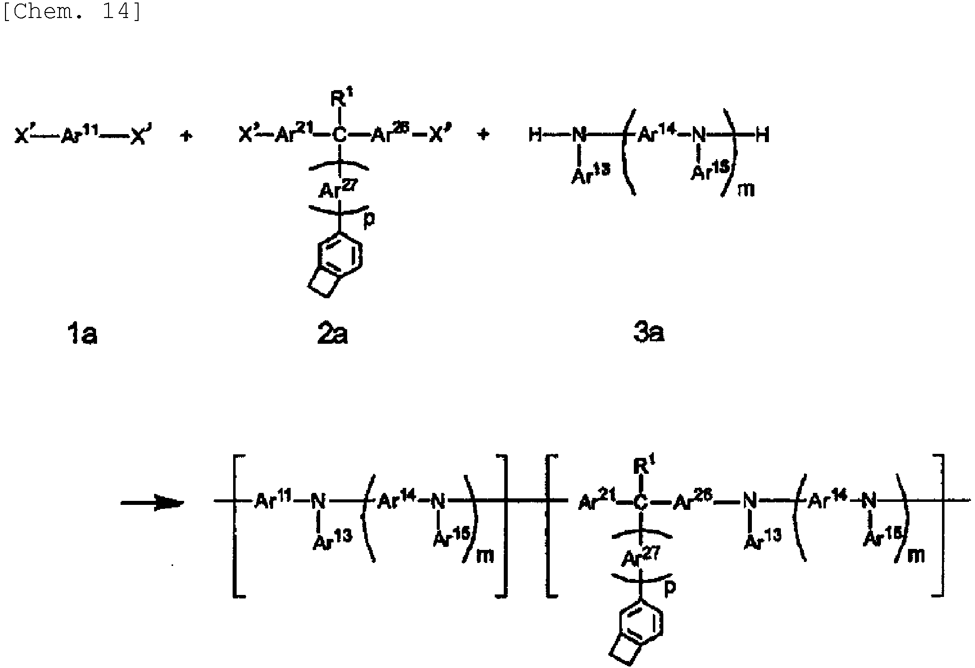

In the reaction formula, each X' is a halogen atom, such as I, Br, Cl, or F.

m is an integer of 0 to 3, and p is an integer of 1 to 6.

Ar¹¹ is a direct bond, an optionally substituted aromatic hydrocarbon group, or an optionally substituted heteroaromatic group.

Ar¹³ to Ar¹⁵ are each independently an optionally substituted aromatic hydrocarbon group or an optionally substituted heteroaromatic group.

Ar²¹ is a direct bond, an optionally substituted aromatic hydrocarbon group, or an optionally substituted heteroaromatic group.

Ar²⁶ and Ar²⁷ are each independently an optionally substituted aromatic hydrocarbon group or an optionally substituted heteroaromatic group.

R¹ is a hydrogen atom, an optionally substituted alkyl group having 1 to 24 carbon atoms, an optionally substituted alkoxy group having 1 to 24 carbon atoms, an optionally substituted aromatic hydrocarbon group, or an optionally substituted heteroaromatic group.

p Ar^{27'}s may be the same or different.

m Ar¹⁴'s may be the same or different from each other, and m Ar¹⁵'s may be the same or different from each other.

In the polymerization method described above, the reaction for the formation of the N-aryl bond is usually performed in the presence of a base, such as potassium carbonate, sodium tert-butoxide, or triethylamine. For example, it can also be performed in the presence of a transition metal catalyst, such as copper, nickel, or palladium.

As the transition metal catalyst, a palladium compound and a phosphine ligand are preferably used.

As the palladium compound, palladium chloride, palladium acetate, bis(dibenzylideneacetone)palladium, or tris(dibenzylideneacetone)dipalladium is preferred.

As the phosphine ligand, tri-tert-butylphosphine, tricyclohexylphosphine, di-tert-butylphenylphosphine, di-tert-butyl(4-dimetylaminophenyl)phosphine, or 2-dicyclohexylphosphino-2',6'-dimethoxybiphenyl is preferred.

In the case of the polymerization method using the Suzuki reaction, for example, boron derivatives represented by formulae 1b and 2b and an aryl dihalide represented by formula 3b are reacted to synthesize the polymer of the present invention.

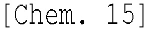

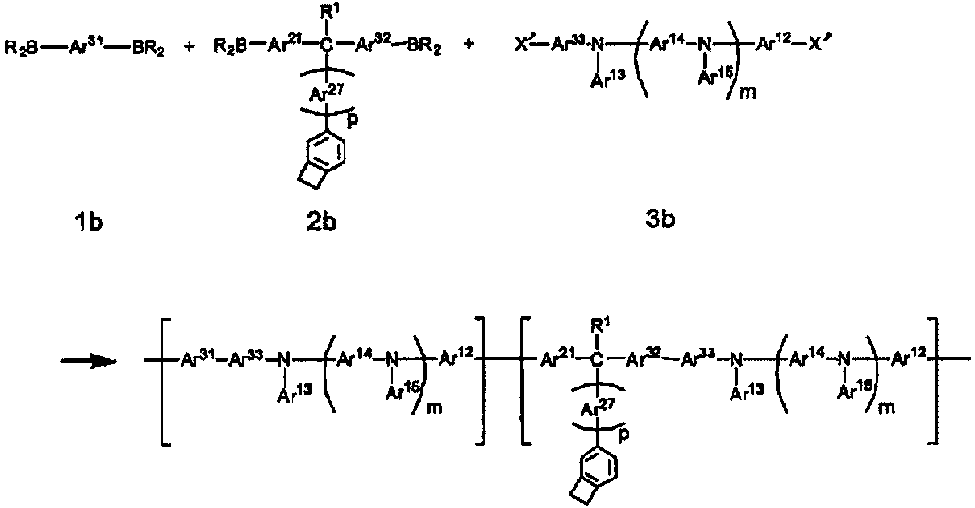

In the reaction formula, each BR₂ is a boronic acid group or a boronic ester group.

Each X' is a halogen atom, such as I, Br, Cl, or F.

m is an integer of 0 to 3, and p is an integer of 1 to 6.

Ar¹² to Ar¹⁵ are each independently an optionally substituted aromatic hydrocarbon group or an optionally substituted heteroaromatic group.

Ar²¹, Ar²⁷, and Ar³¹ to Ar³³ are each independently an optionally substituted aromatic hydrocarbon group or an optionally substituted heteroaromatic group.

R¹ is a hydrogen atom, an optionally substituted alkyl group, an optionally substituted alkoxy group, an optionally substituted aromatic hydrocarbon group, or an optionally substituted heteroaromatic group.

p Ar^{27'}s may be the same or different.

m Ar^{14'}s may be the same or different from each other, and m Ar^{15'}s may be the same or different from each other.

In the polymerization method described above, the reaction step between the boron derivative and the dihalide is usually performed in the presence of a base, such as potassium carbonate, sodium tert-butoxide, or triethylamine. For example, it can also be performed in the presence of a transition metal catalyst, such as copper or a palladium complex, as needed. The reaction step with the boron derivative can be performed in the presence of a base, such as potassium carbonate, potassium phosphate, sodium tert-butoxide, or triethylamine, and a transition metal catalyst, such as a palladium complex.

In addition to the above-mentioned polymerization methods, for example, a polymerization method described in JP2001-223084A, a polymerization method described in JP2003-213002A, a polymerization method described in JP2004-2740A, radical polymerization of a compound having an unsaturated double bond, or a sequential polymerization by a reaction to form an ester bond or an amide bond can be employed for the production of the hole transport polymer of the present invention.

Moreover, known coupling reactions can be used. As a known coupling method, specifically, a coupling reaction between rings, such as a coupling reaction between aryl halide and aryl borate, can be used, the coupling reaction being described or cited in, for example, "Palladium in Heterocyclic Chemistry: A guide for the Synthetic Chemist" (second edition, 2002, Jie Jack Li and Gordon W. Gribble, Pergamon), "Sen-i Kinzoku ga Hiraku Yuuki Gousei, Sono Tasai na Hannou Keishiki to Saishin no Seika (Organic Synthesis with Transition Metal, Various Reaction Schemes and The Latest Achievements)" (1997, Jiro Tsuji, Kagaku-Dojin Publishing Co., Inc.), "Vollhardt-Schore, Gendai Yuuki Kagaku (Organic Chemistry, Structure and Function, Vollhardt, Schore, vol. 2) (2004, K. P. C. Vollhardt, Kagaku-Dojin Publishing Co., Inc).

As described above, the group represented by any of formulae (1A) to (1I) may be bonded to a monomer serving as a raw material of the hole transport polymer of the present invention in advance, and then the resulting monomer may be polymerized to give the hole transport polymer of the present invention. Alternatively, a portion serving as the main chain of the hole transport polymer of the present invention may be synthesized, and then the group represented by any of formulae (1A) to (1I) may be bonded to a target site.

As a method for purifying a compound, known techniques including methods described in the following documents may be used: "Bunri Seisei Gijyutsu Handbook (Separation and Purification Technique Handbook)", 1993, edited by The Chemical Society of Japan Foundation, "Kagaku Henkanhou ni yoru Biryou Seibun oyobi Nanseisei Busshitsu no Koudo Bunri (High Separation of Trace Components and Poorly Purifiable Substances by Chemical Transformation)", 1988, published by IPC, and Section "Bunri to Seisei (Separation and Purification)" in "Jikken Kagaku Kouza (Laboratory Chemistry Course), 4th Ed. 1", 1990, edited by The Chemical Society of Japan Foundation. Specific examples thereof include extraction (including suspension washing, boil washing, ultrasonic washing, and acid-base washing), adsorption, occlusion, melting, crystallization (including recrystallization in a solvent and reprecipitation), distillation (atmospheric distillation and reduced-pressure distillation), evaporation, sublimation (atmospheric sublimation and reduced-pressure sublimation), ion exchange, dialysis, filtration, ultrafiltration, reverse osmosis, pressure osmosis, zone melting, electrophoresis, centrifugation, floatation separation, precipitation separation, magnetic separation, and various chromatographies (classification by shape: column, paper, thin layer, capillary; classification by mobile phase: gas, liquid, micelle, supercritical fluid; separation mechanism: adsorption, distribution, ion exchange, molecular sieve, chelate, gel filtration, exclusion, and affinity).

The identification of a product and the analysis of the purity thereof can be performed by applying a procedure or an apparatus, as needed. Examples of the procedure and the apparatus include gas chromatographs (GC), high-performance liquid chromatographs (HPLC), high-speed amino acid analyzers (organic compound), capillary electrophoresis measurement (CE), size exclusion chromatographs (SEC), gel permeation chromatographs (GPC), cross fractionation chromatographs (CFC), mass spectrometry (MS, LC/MS, GC/MS, MS/MS), nuclear magnetic resonance apparatuses (NMR (¹H NMR, ¹³C NMR)), Fourier transform infrared spectrophotometers (FT-IR), ultraviolet-visible-near-infrared spectrophotometers (UV, VIS, NIR), electron spin resonance spectrometers (ESR), transmission electron microscopes (TEM-EDX), electron probe microanalyzers (EPMA), metal element analyses (ion chromatographs, inductively coupled plasma atomic emission spectroscopy (ICP-AES), atomic absorption spectrometry (AAS), X-ray fluorescence spectrometers (XRF)), nonmetal element analyses, and trace analyses (ICP-MS, GF-AAS, GD-MS).

### <Hole Transport Layer>

The hole transport layer of the organic photodiode of the present invention is formed using the above-mentioned hole transport polymer of the present invention by, preferably, a wet film formation process.

In the case of the formation of the hole transport layer by the wet film formation process, a hole transport layer formation composition containing the hole transport polymer of the present invention and a solvent (hereinafter, referred to as a "hole transport layer formation composition of the present invention", in some cases) is used.

The solvent is preferably one that dissolves the hole transport polymer of the present invention. The solvent usually dissolves the hole transport polymer of the present invention in an amount of 0.05% or more by weight, preferably 0.5% or more by weight, more preferably 1% or more by weight at ordinary temperatures.

Preferred examples of the solvent contained in the hole transport layer formation composition of the present invention include, but are not particularly limited to, ether solvents, ester solvents, aromatic hydrocarbon solvents, and amide solvents because the hole transport polymer of the present invention need to be dissolved therein.

Examples of ether solvents include aliphatic ethers such as ethylene glycol dimethyl ether, ethylene glycol diethyl ether, and propylene glycol-1-monomethyl ether acetate (PGMEA) and aromatic ethers such as 1,2-dimethoxybenzene, 1,3-dimethoxybenzene, anisole, phenetole, 2-methoxytoluene, 3-methoxytoluene, 4-methoxytoluene, 2,3-dimethylanisole, and 2,4-dimethylanisole.

Examples of ester solvents include aromatic esters such as phenyl acetate, phenyl propionate, methyl benzoate, ethyl benzoate, propyl benzoate, and n-butyl benzoate.

Examples of aromatic hydrocarbon solvents include toluene, xylene, cyclohexylbenzene, 3-isopropylbiphenyl, 1,2,3,4-tetramethylbenzene, 1,4-diisopropylbenzene, cyclohexylbenzene, and methylnaphthalene.

Examples of amide solvents include N,N-dimethylformamide and N,N-dimethylacetamide.

Other solvents such as dimethyl sulfoxide can also be used.

The concentration of the hole transport polymer of the present invention in the hole transport layer formation composition of the present invention is freely selected as long as the advantageous effects of the present invention are not greatly impaired. The concentration is preferably low in terms of thickness uniformity, and is preferably high in terms of the defect resistance of the hole transport layer. Specifically, the concentration is preferably 0.01% or more by weight, more preferably 0.1% or more by weight, particularly preferably 0.5% or more by weight, and preferably 70% or less by weight, more preferably 60% or less by weight, particularly preferably 50% or less by weight.

The concentration of the solvent in the hole transport layer formation composition of the present invention is usually 10% or more by weight, preferably 30% or more by weight, more preferably 50% or more by weight.

In the case of forming the hole transport layer with the hole transport layer formation composition of the present invention, the hole transport layer formation composition is applied and then usually heated. A method for heating the layer formed with the hole transport layer formation composition of the present invention is not particularly limited. In the case of drying by heating, the heating temperature is usually 100°C or higher, preferably 120°C or higher, more preferably 150°C or higher, and usually 400°C or lower, preferably 350°C or lower, more preferably 300°C or lower. The heating time is usually 1 minute or more, preferably 24 hours or less. An example of a heating method that can be used is, but not particularly limited to, a method in which a multilayer stack including the resulting layer is heated on a hot plate or in an oven. For example, conditions where heating is performed on a hot plate at 120°C or higher for 1 minute or more can be used.

The hole transport layer usually has a thickness of 5 nm or more, preferably 10 nm or more, and usually 300 nm or less, preferably 100 nm or less.

When the thickness of the hole transport layer is the lower limit or more, the arrangement of the hole transport layer serving as a blocking layer effectively provides the effect of reducing the dark current. When the thickness of the hole transport layer is the upper limit or less, a large incident angle of light in a CMOS sensor including the organic photodiode of the present invention can be obtained. Additionally, the organic photodiode can have a small thickness.

To effectively reduce the dark current, the hole transport layer preferably has a LUMO level of 0.3 eV or more, 0.5 eV or more, more preferably 1.0 eV or more shallower than the n-type semiconductor of the photoelectric conversion layer.

The hole transport layer plays a role in efficiently transport holes generated in the photoelectric conversion layer to the first electrode. Thus, the difference in HOMO level between the hole transport layer and the p-type semiconductor of the photoelectric conversion layer is preferably within 0.5 eV, preferably within 0.3 eV.

### <Substrate>

The organic photodiode of the present invention includes the first electrode, the hole transport layer, the photoelectric conversion layer, and the second electrode stacked in that order and is usually provided with a substrate to support these layers. The substrate may be disposed on either the first electrode side or the second electrode side or may be disposed on each side. The substrate is preferably disposed at least on the first electrode side.

The substrate can be composed of any material. In the case where light is incident on the side of the substrate, the substrate needs to be composed of a highly transparent material.

Examples of a constituent material of the substrate include inorganic materials, such as glass, sapphire, and titania; organic materials, such as poly(ethylene terephthalate), poly(ethylene naphthalate), poly(ether sulfone), polyimide, nylon, polystyrene, poly(vinyl alcohol), ethylene-vinyl alcohol copolymers, fluorocarbon resins, vinyl chloride, polyethylene, cellulose, poly(vinylidene chloride), aramid, poly(phenylene sulfide), polyurethane, polycarbonate, polyarylate, and polynorbornene; paper materials, such as paper and synthetic paper; and composite materials, such as a material in which a surface of a metal, such as stainless steel, titanium, or aluminum, is coated or laminated in order to impart insulating properties to the metal. These constituent materials of the substrate may be used alone or in any combination of two or more and in any ratio.

The shape and dimensions of the substrate are not limited and can be freely set.

The substrate may be laminated with another layer in order to impart gas barrier properties thereto and to control the surface state.

The thickness of the substrate can be freely designed in accordance with, for example, the application of the organic photodiode and the constituent material. An excessively small thickness of the substrate results in a failure to function as a supporting member due to insufficient strength. An excessively large thickness leads to an increase in cost. Usually, the substrate is in the form of a film or plate having a thickness of about 10 µm to about 50 mm.

### <Electrode>

The electrodes (the first electrode and the second electrode) can be composed of any conductive material.

Examples of a constituent material of the electrodes include metals, such as platinum, gold, silver, aluminum, chromium, nickel, copper, titanium, magnesium, calcium, barium, and sodium, and alloys thereof; metal oxides, such as indium oxide and tin oxide, and composite oxides thereof (for example, ITO and IZO); conducting polymers, such as polyaniline, polypyrrole, polythiophene, and polyacetylene; materials in which the above-mentioned conducting polymers are each doped with a dopant, such as an acid, e.g., hydrochloric acid, sulfuric acid, or sulfonic acid, a Lewis acid, e.g., FeCl₃, a halogen atom, e.g., iodine, or a metal atom, e.g., sodium or potassium; and conducting composite materials, such as matrices, e.g., polymer binders, containing conducting particles, such as metal particles, carbon black, fullerene, or carbon nanotube, dispersed therein. These constituent materials of the electrodes may be used alone or in combination of two or more and in any ratio.

In the organic photodiode, at least a pair of electrodes (two electrodes) is disposed, and the photoelectric conversion layer is disposed between the pair of electrodes. At least one electrode in the pair of electrodes is preferably transparent (that is, it transmits light to be absorbed by the photoelectric conversion layer for the purpose of generating electrical energy).

Examples of a material of the transparent electrode include composite oxides, such as indium-tin oxide (ITO) and indium-zinc oxide (IZO); and thin metal films.

The specific range of light transmittance is preferably, but not necessarily, 80% or more in view of the photoelectric conversion efficiency of the organic photodiode. The light transmittance can be measured with an ordinary spectrophotometer.

The electrodes have the function of collecting the holes and electrons generated in the photoelectric conversion layer. Thus, as the constituent material of the electrodes, it is preferable to use a constituent material suitable for collecting holes and electrons among the above-mentioned materials. Examples of electrode materials suitable for collecting holes include materials with high work functions, such as Au and ITO. Examples of electrode materials suitable for collecting electrons include materials with low work functions, such as Al.

The thickness of each electrode is not particularly limited, and is appropriately determined in view of, for example, a material used and conductivity and transparency required. The electrodes usually have a thickness of about 10 nm to about 100 µm.

There are no restrictions on a method for forming the electrodes. The electrodes can be formed, for example, by a dry process, such as vacuum deposition or sputtering. Alternatively, the electrodes can also be formed, for example, by a wet process using a conductive ink or the like. In this case, any conductive ink can be used. Examples of the conductive ink that can be used include conducting polymers and metal particle-containing dispersions. Each electrode may be a stack of two or more layers and may be subjected to surface treatment in order to improve the characteristics (such as electrical characteristics and wetting characteristics).

### <Photoelectric Conversion Layer>

The photoelectric conversion layer is a layer that absorbs light and separates charges. The photoelectric conversion layer of the organic photodiode of the present invention includes the p-type semiconductor and the n-type semiconductor. The photoelectric conversion layer has a bulk heterojunction structure formed of a mixed semiconductor film containing the p-type semiconductor and the n-type semiconductor. Thus, the short distance between the p-type semiconductor and the n-type semiconductor enables the organic photodiode to have high photoelectric conversion efficiency.

As each of the p-type semiconductor and the n-type semiconductor contained in the photoelectric conversion layer according to the present invention, any of quinacridone derivatives, naphthalene derivatives, anthracene derivatives, phenanthrene derivatives, tetracene derivatives, pyrene derivatives, perylene derivatives, and fluoranthene derivatives can be particularly preferably used.

The p-type semiconductor (compound) is a donor semiconductor (compound) and refers to a compound having a property of easily donating electrons, mainly represented by a hole transport compound. More specifically, it refers to a compound having a smaller ionization potential when two materials are used in contact with each other. Thus, as the donor compound, any compound can be used as long as it is an electron-donating compound. Examples of the donor compound that can be used include triarylamine compounds, benzidine compounds, pyrazoline compounds, styrylamine compounds, hydrazone compounds, triphenylmethane compounds, carbazole compounds, polysilane compounds, thiophene compounds, phthalocyanine compounds, cyanine compounds, merocyanine compounds, oxonol compounds, polyamine compounds, indole compounds, pyrrole compounds, pyrazole compounds, polyarylene compounds, fused aromatic carbocyclic ring compounds (naphthalene derivatives, anthracene derivatives, phenanthrene derivatives, tetracene derivatives, pyrene derivatives, perylene derivatives, and fluoranthene derivatives), and metal complexes each having a nitrogen-containing heterocyclic compound as a ligand.

The donor compound is not limited thereto. As described above, a compound having a smaller ionization potential than a compound used as an n-type (acceptor) compound may be used as the donor semiconductor.

The n-type semiconductor (compound) is an acceptor semiconductor (compound) and refers to a compound having a property of easily accepting electrons, mainly represented by an electron transport compound. More specifically, it refers to a compound having higher electron affinity when two materials are used in contact with each other. Thus, as the acceptor compound, any compound can be used as long as it is an electron-accepting compound.

Examples of the acceptor compound include fused aromatic carbocyclic ring compounds (naphthalene derivatives, anthracene derivatives, phenanthrene derivatives, tetracene derivatives, pyrene derivatives, perylene derivatives, and fluoranthene derivatives), five- to seven-membered heterocyclic compounds each containing a nitrogen atom, an oxygen atom, or sulfur atom (for example, pyridine, pyrazine, pyrimidine, pyridazine, triazine, quinoline, quinoxaline, quinazoline, phthalazine, cinnoline, isoquinoline, pteridine, acridine, phenazine, phenanthroline, tetrazole, pyrazole, imidazole, thiazole, oxazole, indazole, benzimidazole, benzotriazole, benzoxazole, benzothiazole, carbazole, purine, triazolopyridazine, triazolopyrimidine, tetrazaindene, oxadiazole, imidazopyridine, pyralidine, pyrrolopyridine, thiadiazolopyridine, dibenzazepine, and tribezazepine), polyarylene compounds, fluorene compounds, cyclopentadiene compounds, silyl compounds, and metal complexes each having a nitrogen-containing heterocyclic compound as a ligand.

The acceptor compound is not limited thereto. As described above, a compound having higher electron affinity than a compound used as a donor compound may be used as the acceptor semiconductor.

In the case where a compound having a fullerene skeleton is used as the n-type semiconductor, even when a bulk heterojunction structure is used for the purpose of increasing the photoelectric conversion efficiency, the presence of the bulky fullerene skeleton allows the distance between the n-type semiconductor and the p-type semiconductor to increase, thereby decreasing the photoelectric conversion efficiency.

Accordingly, in the n-type semiconductor in the present invention, the percentage of an n-type semiconductor having a fullerene skeleton is preferably 10% or less by weight based on an n-type semiconductor having no fullerene skeleton. More preferably, substantially no n-type semiconductor having a fullerene skeleton is contained.

Here, the expression "substantially no n-type semiconductor having a fullerene skeleton is contained" indicates that the non-fullerene-type n-type semiconductor skeleton plays a role in transporting electrons among charges generated in the photoelectric conversion layer, and a small amount of the n-type semiconductor having a fullerene skeleton can be contained to improve the morphology of the photoelectric conversion layer. For such a purpose, usually, the n-type semiconductor having a fullerene skeleton is contained in an amount of 5% or less by weight, preferably 2% or less by weight based on the non-fullerene-type n-type semiconductor skeleton having no fullerene skeleton.

Patent Literature 3 mentioned above discloses that the problem of the generation of the dark current due to the contact between the p-type semiconductor and the n-type semiconductor in a bulk heterojunction structure is suppressed by introducing a fullerene skeleton into the n-type semiconductor. However, the introduction of the fullerene skeleton into the n-type semiconductor decreases the effect of the bulk heterojunction structure, thereby decreasing the photoelectric conversion efficiency.

In the present invention, the problem of the generation of the dark current due to the bulk heterojunction structure can be suppressed by the use of the hole transport layer composed of the hole transport polymer of the present invention. Thus, the n-type semiconductor having no fullerene skeleton is used, and the effect of the bulk heterojunction structure on an improvement in photoelectric conversion efficiency is effectively provided.

Regarding the proportions of the p-type semiconductor and the n-type semiconductor contained in the photoelectric conversion layer, the ratio by weight of the n-type semiconductor to the p-type semiconductor (n-type semiconductor/p-type semiconductor, ratio by weight) is 0.5 to 2.5 times, particularly preferably 1.0 to 2.0 times. In the case where the proportion of the n-type semiconductor is higher than the above range and where the proportion of the p-type semiconductor is lower than the above range, the sensitivity in the near-infrared region tends to decrease. Conversely, in the case where the proportion of the p-type semiconductor is higher than the above range and where the proportion of the n-type semiconductor is lower than the above range, the dark current tends to be easily generated.

In the present invention, any of various known n-type semiconductors can be used as the n-type semiconductor of the photoelectric conversion layer. A preferred example thereof is an n-type semiconductor represented by formula (4) illustrated below.

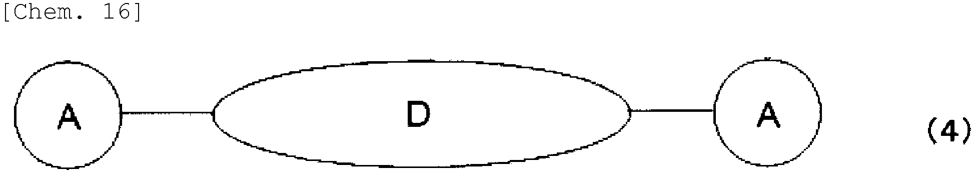

In formula (4), D is a donor site containing an polycyclic aromatic moiety, and each A is an acceptor site containing a malononitrile group.

An example of a more preferred structure is an n-type semiconductor represented by formula (5) illustrated below.

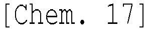

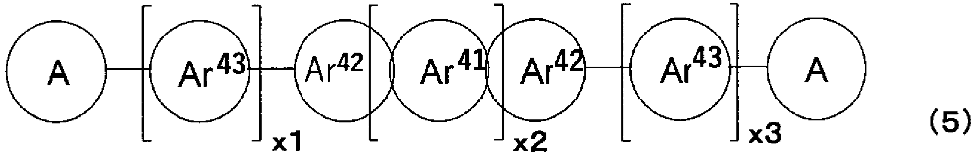

In formula (5), each Ar⁴¹ is independently represented by any of formulae (5a-1) to (5g-1) illustrated below.

Each Ar⁴² is independently represented by any of formulae (5a-2) to (5d-2) illustrated below.

Each Ar⁴³ is independently represented by any of formulae (5a-3) to (5d-3) illustrated below.

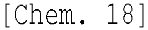

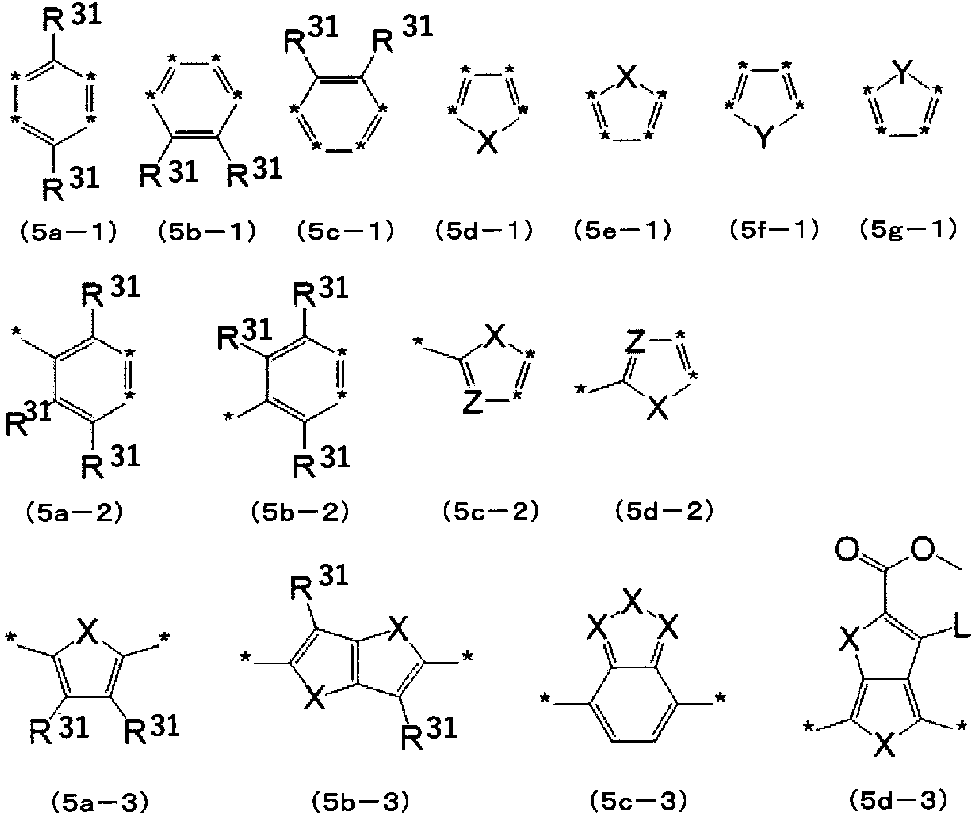

In formulae (5a-1) to (5g-1), (5a-2) to (5d-2), and (5a-3) to (5d-3), each * is a binding site.

Each X is C=O, O, S, or Se.

Y is CR³¹R³¹, SiR³¹R³¹, GeR³¹R³¹, NR³¹, or C=O.

Each Z is CR³¹ or N.

L is R³¹ or a halogen atom.

Each R³¹ is independently a hydrogen atom, an optionally branched alkyl group having 1 to 30 carbon atoms, an optionally branched alkoxy group having 1 to 30 carbon atoms, or a phenyl group optionally substituted with an optionally branched alkyl group having 1 to 30 carbon atoms and/or an optionally branched alkoxy group having 1 to 30 carbon atoms.

Each A is an acceptor site containing a malononitrile group.

x1 is 0 or 1, x2 is an integer of 1 to 6, x3 is 0 or 1.

In formula (5), formulae (5f-1) and (5g-1) are not adjacent to each other.

An example of an even more preferred n-type semiconductor is an n-type semiconductor in which each A that is the acceptor site containing the malononitrile group is represented by any of formulae (5A) to (5C) illustrated below.

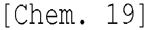

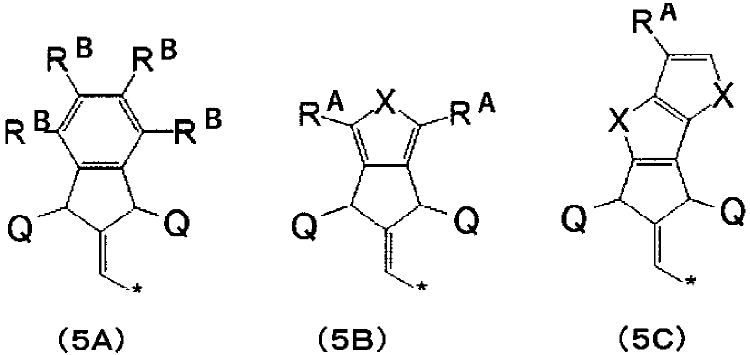

In formulae (5A) to (5C), each * is a binding site.

Each Q is a malononitrile group or O=, at least one of Q's is a malononitrile group.

Each X is C=O, O, S, or Se.

Each R^{A} is independently a hydrogen atom, a halogen atom, an optionally branched alkyl group having 1 to 30 carbon atoms, an optionally branched alkoxy group having 1 to 30 carbon atoms, or a phenyl group optionally substituted with an optionally branched alkyl group having 1 to 30 carbon atoms and/or an optionally branched alkoxy group having 1 to 30 carbon atoms.

Each R^{B} is defined the same as R^{A}, or adjacent R^{B'}s are taken together to form a six-membered aromatic ring.

In the case of the n-type semiconductor having the structure represented by formula (4), an intramolecular interaction occurs, which is preferred in terms of the electron mobility and the photoelectric conversion efficiency.

In formula (5), in the case where Ar⁴¹ has a structure represented by any of formulae (5a-1) to (5g-1) illustrated above and where Ar⁴² has a structure represented by any of formulae (5a-2) to (5d-2), the planarity and the electron-donating properties of the donor site are improved to strengthen the intramolecular interaction of the n-type semiconductor, which is preferred in terms of the electron mobility and the photoelectric conversion efficiency and from the viewpoint of lengthening the wavelength of light absorbed.

In the n-type semiconductor, in the case where Ar⁴³ has a structure represented by any of formulae (5a-3) to (5d-3), the electron-donating properties of the donor site is further enhanced to lengthen the wavelength of light absorbed, which is preferred.

In formula (5), in the case where each acceptor site A has a structure represented by any of formulae (5A) to (5C), the planarity and the electron-withdrawing properties of the acceptor sites can be improved to strengthen the intermolecular interaction of the n-type semiconductor, which is preferred in terms of the electron mobility and the photoelectric conversion efficiency.

A method for forming the photoelectric conversion layer having the bulk heterojunction structure is not particularly limited. For example, the photoelectric conversion layer can be formed by a wet film formation process using a photoelectric conversion layer formation composition prepared by dissolving predetermined amounts of the p-type semiconductor and the n-type semiconductor in an appropriate solvent.

As the solvent used for the photoelectric conversion layer formation composition, a solvent that can dissolve the p-type semiconductor and the n-type semiconductor may be used. Examples thereof include aromatic solvents, such as toluene, xylene, mesitylene, and cyclohexylbenzene; halogen-containing solvents, such as 1,2-dichloromethane, chlorobenzene, and o-dichlorobenzene; ether solvents, such as aliphatic ethers, e.g., ethylene glycol dimethyl ether, ethylene glycol diethyl ether, and propylene glycol-1-monomethyl ether acetate (PGMEA), and aromatic ethers, e.g., 1,2-dimethoxybenzene, 1,3-dimethoxybenzene, anisole, phenetole, 2-methoxytoluene, 3-methoxytoluene, 4-methoxytoluene, 2,3-dimethylanisole, and 2,4-dimethylanisole; aliphatic ester solvents, such as ethyl acetate, n-butyl acetate, ethyl lactate, and n-butyl lactate; ester solvents, such as aromatic esters, e.g., phenyl acetate, phenyl propionate, methyl benzoate, ethyl benzoate, isopropyl benzoate, propyl benzoate, and n-butyl benzoate.

The thickness of the photoelectric conversion layer according to the present invention can be freely designed in accordance with the structure of the photoelectric conversion layer and the application of the organic photodiode. An excessively small thickness of the photoelectric conversion layer results in insufficient light absorption to decrease the efficiency. An excessively large thickness results in an increase in internal resistance to increase the loss. The photoelectric conversion layer usually has a thickness of about 10 nm to about 1 µm.

### <Electron Transport Layer>

The electron transport layer is not necessarily required for the organic photodiode of the present invention. However, the arrangement of the electron transport layer between the photoelectric conversion layer and the second electrode can enhance the photoelectric conversion efficiency and can reduce the dark current.

The electron transport layer is composed of a compound that can efficiently transport electrons generated in the photoelectric conversion layer to the second electrode. An electron transport compound used for the electron transport layer needs to be a compound that has high electron injection efficiency from the photoelectric conversion layer and high electron mobility and that can efficiently transport electrons injected.

For this reason, the difference in LUMO level between the electron transport layer and the n-type semiconductor of the photoelectric conversion layer is preferably 1.5 eV or less, preferably 1.0 eV.

In the case of reducing the dark current with the electron transport layer, the electron transport layer preferably has a HOMO level of 0.3 eV or more, preferably 0.5 eV or more, more preferably 1.0 eV or more deeper than the p-type semiconductor of the photoelectric conversion layer.

Examples of the electron transport compound used for the electron transport layer include metal complexes, such as an aluminum complex of 8-hydroxyquinoline (JP59-194393A), metal complexes of 10-hydroxybenzo[h]quinoline, oxadiazole derivatives, distyrylbiphenyl derivatives, silole derivatives, 3-hydroxyflavone metal complexes, 5-hydroxyflavone metal complexes, benzoxazole metal complexes, benzothiazole metal complexes, trixbenzimidazolylbenzene (U.S. Patent No. 5,645,948), quinoxaline compounds (JP6-207169A), phenanthroline derivatives (JP5-331459A), 2-tert-butyl-9,10-N,N'-dicyanoanthraquinonediimine, n-type hydrogenated amorphous silicon carbide, n-type zinc sulfide, and n-type zinc selenide.

As a material used for the formation of the electron transport layer, a metal oxide, such as titanium oxide, zinc oxide, tin oxide, or cerium oxide, can also be used. In this case, as a method for forming the electron transport layer, a method in which metal oxide nanoparticles are formed into a film by a wet process and dried to give a metal oxide layer, or a method in which a precursor is formed into a film by a wet process and converted by heating can be employed.

The electron transport layer usually has a thickness of 1 nm or more, preferably 5 nm or more, and usually 300 nm or less, preferably 100 nm or less.

The electron transport layer can be formed by a wet film formation process or a vacuum evaporation method. Usually, the vacuum evaporation method is employed.

### <Other Constituent Layers>

The organic photodiode of the present invention may include other constituent layers other than the substrate, the first and second electrodes, the hole transport layer, the photoelectric conversion layer, or the electron transport layer described above as long as the advantageous effects of the present invention are not greatly impaired.

For example, the organic photodiode may include a protective film so as to cover a photoelectric conversion layer portion and even electrode portions in order to minimize the effect of the ambient air. The protective layer can be formed of a polymer film composed of, for example, styrene resin, epoxy resin, acrylic resin, polyurethane, polyimide, poly(vinyl alcohol), poly(vinylidene fluoride), or a polyethylene-poly(vinyl alcohol) copolymer; an inorganic oxide or nitride film, such as silicon oxide, silicon nitride, or aluminum oxide; or a multilayer film thereof.

A method for forming the protective film is not limited.

For example, in the case where the protective film is a polymer film, examples thereof include a formation method in which a polymer solution is applied and dried, and a formation method in which a monomer is applied or vapor-deposited and polymerized.

When the polymer film is formed, it is also possible to perform crosslinking treatment or to form a multilayer film.

In the case where the protective film is formed of an inorganic film, such as an inorganic oxide or nitride film, examples of the formation method that can be employed include vacuum processes, such as a sputtering method and a vapor deposition method; and solution processes typified by a sol-gel method.

To allow the electrodes to efficiently collect charges generated in the photoelectric conversion layer, a charge injection layer may be disposed between the first electrode and the hole transport layer or between the electron transport layer and the second electrode.

The organic photodiode may include, for example, an optical filter that does not transmit ultraviolet radiation on the light incident side. Typically, ultraviolet radiation often accelerates the deterioration of the organic photodiode. Thus, the lifetime of the organic photodiode can be extended by blocking ultraviolet radiation.

### <Method for Producing Organic Photodiode>

The organic photodiode of the present invention is usually produced by stacking the first electrode, the hole transport layer, the photoelectric conversion layer, and the second electrode, in that order, on the substrate by the above-mentioned method. A step of forming an electron transport layer or the like provided between the layers is performed, as needed.

### [Infrared CMOS Sensor]

The infrared CMOS sensor of the present invention is an infrared CMOS sensor including the organic photodiode of the present invention. The infrared CMOS sensor of the present invention can have the structure of a conventional common infrared CMOS sensor, except that the organic photodiode of the present invention is used as the organic photodiode. The infrared CMOS sensor of the present invention can have a structure as illustrated in Fig. 2, for example.

In the infrared CMOS sensor illustrated in Fig. 2, the organic photodiode 10 including a protective film 3 is disposed on a metal wiring layer 4 on a silicon substrate 5 including transistors 6 and a signal storage portion 7. Microlenses 1 are disposed on the organic photodiode 10 with a color filter 2 provided therebetween. The color filter 2 includes R, G, and B that are depicted for convenience in Fig. 2. Alternatively, a visible-light cut filter may be disposed in such a manner that the sensor is sensitive only to near-infrared radiation.

The lower electrode 11 of the organic photodiode 10 is divided into sections corresponding to the colors R, G, and B of the color filter 2. The organic photoelectric film 20 of the organic photodiode 10 includes the hole transport layer 12, the photoelectric conversion layer 13, and the electron transport layer 14 stacked from the lower electrode 11 side, as illustrated in Fig. 1.

The sections of the lower electrode 11 corresponding to the respective colors of R, G, and B of the color filter 2, the upper electrode 15 opposite thereto, and portions of the photoelectric conversion layer interposed therebetween provides photoelectric conversion elements corresponding to the colors of the color filter 2.

Light incident on the infrared CMOS sensor is absorbed by the organic photodiode 10 through the microlenses 1 and the color filter 2 provided for each pixel to generate electron-hole pairs. The electrons generated are withdrawn to the lower electrode 11 side in accordance with the strength of an electric field applied to the photoelectric conversion layer 13 and stored in the signal storage portion 7 as signal charges.

### EXAMPLES

While the present invention will be described in more detail below by examples, the present invention is not limited to these examples described below so long as the present invention does not depart from the scope of the invention.

### [Evaluation Method]

A method for measuring performance for organic photodiodes produced in the examples and comparative examples below will be described below.

The value of the external quantum efficiency at a wavelength of 940 nm was obtained from the measurement of spectral sensitivity with a solar simulator and electrical characteristic measurement system (available from Bunkoukeiki Co., Ltd.) when a voltage of -1 V was applied to the element.

A dark box was placed in the system. The value of the dark current density per unit area was obtained by current-voltage measurement with a 2400 source meter when a voltage of -1 V was applied to the element.

A light-shielding mask having an opening of 1 mm square was disposed on the light-receiving portion of the element. The photoelectric conversion efficiency for light having a wavelength of 850 nm was measured with a PEC-S20 action spectrum measurement device, available from Peccell Technologies, Inc.

In the measurement, light was incident on the side of an ITO substrate.

### <Example 1>

An organic photodiode was produced by the following method.

A surface of an indium-tin oxide (ITO) substrate in which a transparent conductive film pattern serving as an electrode, having a thickness of 150 nm, and being composed of ITO had been formed on a glass substrate was treated with an ultraviolet-ozone cleaner (NL-UV253, available from Nippon Laser and Electronics Laboratory) for 10 minutes. Then a hole transport layer was formed as described below.

First, 16 mg of a polymer represented by formula (H4) (Mw = 64,000, Mn = 43,000, and Mw/Mn = 1.5) was dissolved in 1 mL of toluene to prepare a hole transport layer formation composition.

In formula (H4), Ar in a repeat unit contained at a ratio of 0.95 is a 9,9-di-n-hexyl-2-fluorenyl group marked with 0.95 below and is not randomly contained in a ratio of 0.95:0.05. The same is true for a repeat unit marked with 0.05.

This composition was spin-coated on the electrode surface of the ITO substrate in a nitrogen atmosphere at a rotation speed of 1,500 rpm for 30 seconds and dried by heating at 240°C for 30 minutes to form a hole transport layer having a thickness of 92 nm. The polymer represented by formula (H4) polymerizes even during the drying by heating at 230°C and does not cause any problems in subsequent coating steps.

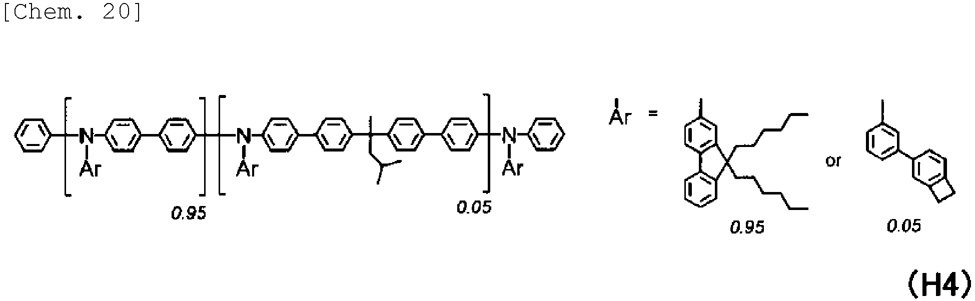

A photoelectric conversion layer was formed on the hole transport layer as described below.

Regarding the photoelectric conversion layer, a PCE-10 p-type semiconductor (available from Aldrich) and a compound represented by formula (N2) (in formula (N2), each R is a 2-ethylhexyl group) as an n-type semiconductor material were weighed at a ratio by weight of 1 to 1. Chlorobenzene (available from Aldrich) and 1-chloronaphthalene (available from Aldrich) were added thereto in a ratio by volume of 98:2 to dissolve the p-type semiconductor and the n-type semiconductor, thereby preparing a photoelectric conversion layer formation composition. This composition was spin-coated on the hole transport layer at 1,000 rpm in a nitrogen atmosphere to form the photoelectric conversion layer having a thickness of 150 nm.

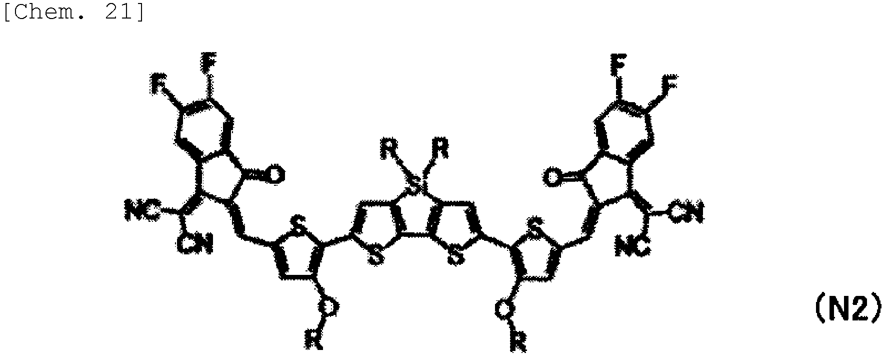

Fullerene C₆₀ (available from Frontier Carbon Corporation) was deposited to a thickness of 40 nm on the resulting photoelectric conversion layer by a vacuum evaporation method, thereby forming an electron transport layer.

Then aluminum was deposited to a thickness of 100 nm on the resulting electron transport layer by a vacuum evaporation method, thereby forming a reflective electrode.

From the measurement of the spectral sensitivity of the resulting organic photodiode, the value of the external quantum efficiency was 38% at a wavelength of 940 nm and an applied voltage of -1 V, and the value of the dark current density per unit area was 1 × 10⁻⁷ A/cm².

### <Comparative Example 1>

An organic photodiode was produced as in Example 1, except that no hole transport layer was formed.

In this organic photodiode, the external quantum efficiency was not able to be accurately measured at a wavelength of 940 nm and an applied voltage of -1 V because of a large amount of leakage current. The dark current density per unit area was 2 × 10⁻³ A/cm².

### <Comparative Example 2>

An organic photodiode was produced as in Example 1, except that the hole transport layer was composed of commercially available PEDOT: PSS (Clevios P VP AI4083, available from Heraeus).

In this organic photodiode, the value of the external quantum efficiency was 36% at a wavelength of 940 nm and an applied voltage of -1 V, and the value of the dark current density per unit area was 3 × 10⁻⁷ A/cm².

Table 1 summarizes the results of Example 1 and Comparative examples 1 and 2.

**[Table 1]**

| | Hole transport layer | External quantum efficiency (%) | Dark current density (A/cm²) |
|---|---|---|---|
| Example 1 | (H3) | 38% | 1 × 10⁻⁷ |
| Comparative example 1 | no | (unmeasurable) | 2 × 10⁻³ |
| Comparative example 2 | commercial item (PEDOT:PSS) | 36% | 3 × 10⁻⁷ |

### <Example 2>

An organic photodiode was produced by the following method.

A 130-nm-thick transparent conductive indium-tin oxide (ITO) film deposited on a glass substrate (deposited by sputtering, sheet resistance: 15 Ω) was patterned into 2-mm-wide stripes by a usual photolithography technique, thereby forming a transparent electrode. The patterned ITO substrate was cleaned by ultrasonic cleaning with ultrapure water, acetone, and isopropyl alcohol in that order, dried by nitrogen blowing, and finally subjected to ultraviolet-ozone cleaning.

First, 4 mg of a polymer represented by formula (H1) (Mw = 85,000, Mn = 60,000, and Mw/Mn = 1.4) was dissolved in 1 mL of toluene to prepare a hole transport layer formation composition. This composition was spin-coated on the electrode surface of the ITO substrate in a nitrogen atmosphere at a rotation speed of 1,500 rpm for 30 seconds and dried by heating at 230°C for 1 hour to form a hole transport layer having a thickness of 25 nm.

In formula (H1), Ar in a repeat unit contained at a ratio of 0.95 is a 9,9-di-n-hexyl-2-fluorenyl group marked with 0.95 below and is not randomly contained in a ratio of 0.95:0.05. The same is true for a repeat unit marked with 0.05.

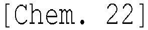

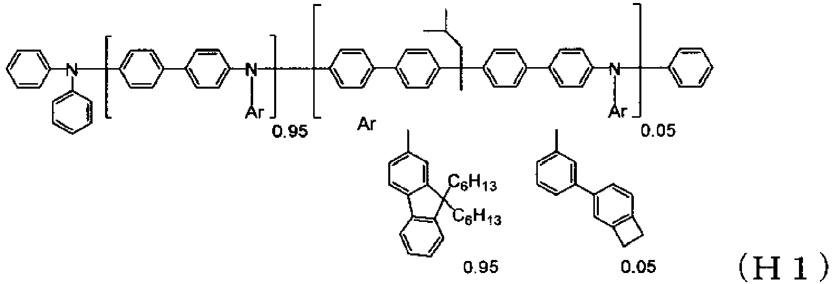

Subsequently, 0.98 mL of chlorobenzene and 0.02 mL of 1,8-diiodooctane were dissolved in 8 mg of a compound represented by formula (P1) and 12 mg of a compound represented by (N1) to prepare a photoelectric conversion layer formation composition. This composition was spin-coated on the hole transport layer in a nitrogen atmosphere at a rotation speed of 2,500 rpm for 60 seconds to form a photoelectric conversion layer having a thickness of 100 nm.

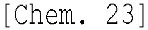

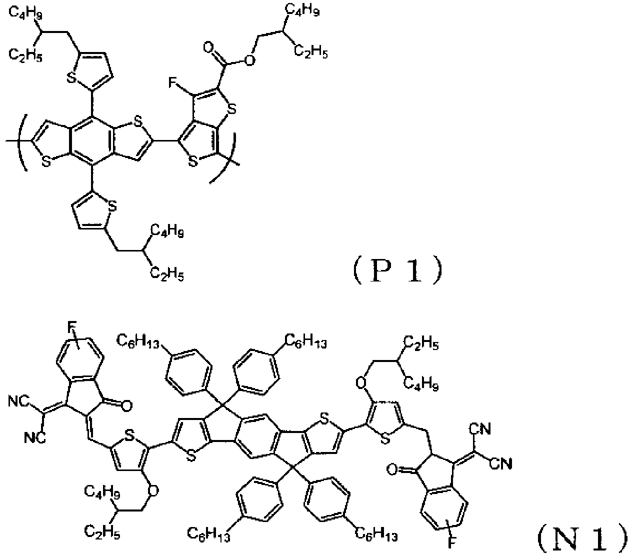

Fullerene C₆₀ (available from Frontier Carbon Corporation) was deposited to a thickness of 40 nm on the resulting photoelectric conversion layer by a vacuum evaporation method, thereby forming an electron transport layer.

Then aluminum was deposited to a thickness of 100 nm on the resulting electron transport layer by a vacuum evaporation method and formed into 2-mm-wide stripes perpendicular to the ITO stripes serving as transparent electrodes, thereby forming a reflective electrode.

As described above, an organic photodiode having light-receiving areas each having a size of 2 mm × 2 mm was produced.

Table 2 presents the measurement results of the dark current density and the photoelectric conversion efficiency of the resulting organic photodiode.

### <Example 3>

An organic photodiode was produced as in Example 2, except that the hole transport layer was formed by the following method.

First, 4 mg of a polymer represented by formula (H2) (Mw = 34,000, Mn = 23,000, Mw/Mn = 1.5, and formula (1) number/1,000 = 0.13) was dissolved in 1 mL of toluene to prepare a hole transport layer formation composition. This composition was spin-coated on the electrode surface of the ITO substrate in a nitrogen atmosphere at a rotation speed of 1,500 rpm for 30 seconds and dried by heating at 230°C for 1 hour to form a hole transport layer having a thickness of 25 nm. In formula (H2), each Ar is a 9,9-di-n-hexyl-2-fluorenyl group in both repeat units.

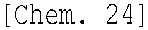

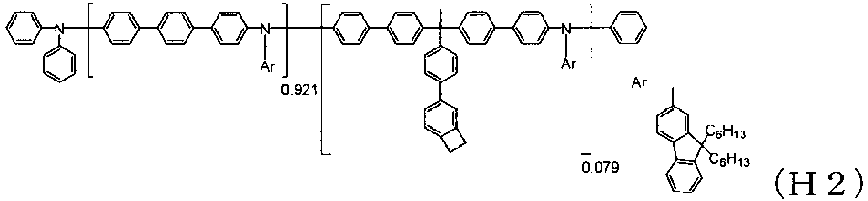

Table 2 presents the measurement results of the dark current density and the photoelectric conversion efficiency of the resulting organic photodiode.

### <Comparative Example 3>

An organic photodiode was produced by the following method.

A solution of 15% by weight diethylzinc in toluene (available from Sigma-Aldrich) was diluted with tetrahydrofuran to a ratio by volume of 1:2 in a nitrogen atmosphere to prepare a composition. This composition was taken out in the atmosphere and spin-coated on an ITO substrate, which had been prepared as in Example 2, at 4,000 rpm for 30 seconds, and converted into zinc oxide by drying at 110°C for 20 minutes, thereby forming an electron transport layer having a thickness of 40 nm.

Subsequently, a photoelectric conversion layer was formed as in Example 2.

Molybdenum trioxide was deposited to a thickness of 7 nm on the resulting photoelectric conversion layer by a vacuum evaporation method, thereby forming a hole transport layer.

Then silver was deposited to a thickness of 100 nm by a vacuum evaporation method and formed into 2-mm-wide stripes perpendicular to the ITO stripes serving as transparent electrodes, thereby forming a reflective electrode.

As described above, an organic photodiode having light-receiving areas each having a size of 2 mm × 2 mm was produced.

Table 2 presents the measurement results of the dark current density and the photoelectric conversion efficiency of the resulting organic photodiode.

### <Comparative Example 4>

A photodiode was produced as in Comparative example 3, except that after the formation of the photoelectric conversion layer, when the hole transport layer was formed, a compound represented by formula (H3) was deposited to a thickness of 20 nm by a vacuum evaporation method, and then molybdenum trioxide was vacuum-deposited to form a hole transport layer formed of two layers of compound (H3) and molybdenum trioxide.

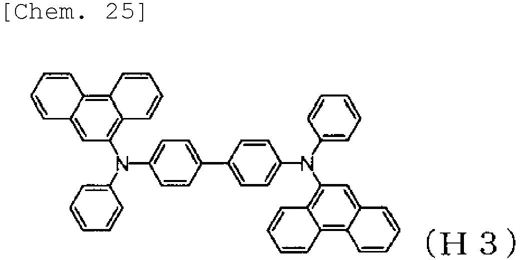

Table 2 presents the measurement results of the dark current density and the photoelectric conversion efficiency of the resulting organic photodiode.

**[Table 2]**

| | Layer structure | Hole transport layer | | Electron transport layer | | Photoelectric conversion efficiency (%) | Dark current density (A/cm²) |
|---|---|---|---|---|---|---|---|
| | | Material | Thickness (nm) | Material | Thickness (nm) | | |
| Example 2 | ITO/hole transport layer/photoelectric conversion layer/electron transport layer/AI | (H1) | 25 | C60 | 40 | 38 | 1.5 × 10⁻⁸ |
| Example 3 | | (H2) | 25 | C60 | 40 | 48 | 1.7 × 10⁻⁸ |
| Comparative example 3 | ITO/electron transport layer/photoelectric conversion layer/hole transport layer/Ag | MoO₃ | 7 | ZnOₓ | 40 | 60 | 1.9 × 10⁻⁶ |
| Comparative example 4 | | MoO₃/(H3 ) | 7/20 | ZnOₓ | 40 | 57 | 2.8 × 10⁻⁷ |

Tables 1 and 2 clearly indicate that in each of the organic photodiode of the present invention, the dark current can be significantly reduced while maintaining the photoelectric conversion efficiency.

While the present invention has been described in detail using a specific embodiment, it should be apparent to those skilled in the art that various modifications can be made without departing from the spirit and scope of the present invention.

The present application is based on Japanese Patent Application No. 2018-238473 filed December 20, 2018, which is incorporated herein by reference in its entirety. Reference Signs List

- 1: microlens
- 2: color filter
- 3: protective film
- 4: metal wiring layer
- 4A: metal wiring
- 5: silicon substrate
- 6: transistor
- 7: signal storage portion
- 10: organic photodiode
- 11: first electrode
- 12: hole transport layer
- 13: photoelectric conversion layer
- 14: electron transport layer
- 15: second electrode
- 20: organic photoelectric film

## Claims

1. An organic photodiode, comprising, in sequence:
a first electrode, a hole transport layer, a photoelectric conversion layer, and a second electrode,
wherein the photoelectric conversion layer contains a p-type semiconductor and an n-type semiconductor,
the hole transport layer contains a polymer compound containing a repeat unit represented by formula (2) described below, and
the polymer compound contains groups that form mutual bonds between carbon atoms of side chains of molecules of the polymer compound at 230°C, 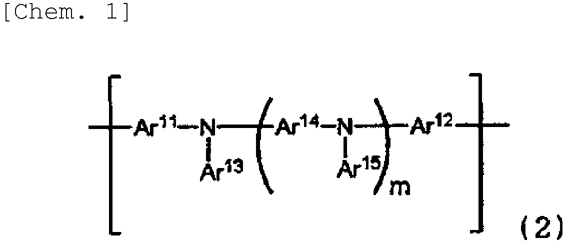
where in formula (2), m is an integer of 0 to 3,
Ar¹¹ and Ar¹² are each independently a direct bond, an optionally substituted aromatic hydrocarbon group, or an optionally substituted heteroaromatic group,
Ar¹³ to Ar¹⁵ are each independently an optionally substituted aromatic hydrocarbon group or an optionally substituted heteroaromatic group,
m Ar¹⁴'s are optionally the same or different from each other, and m Ar¹⁵'s are optionally the same or different from each other,
provided that Ar¹¹ and Ar¹² are not both direct bonds.

2. The organic photodiode according to Claim 1, wherein the groups that form the mutual bonds between the carbon atoms of the side chains at 230°C are each a group represented by any of formulae (1A) to (1I), 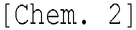 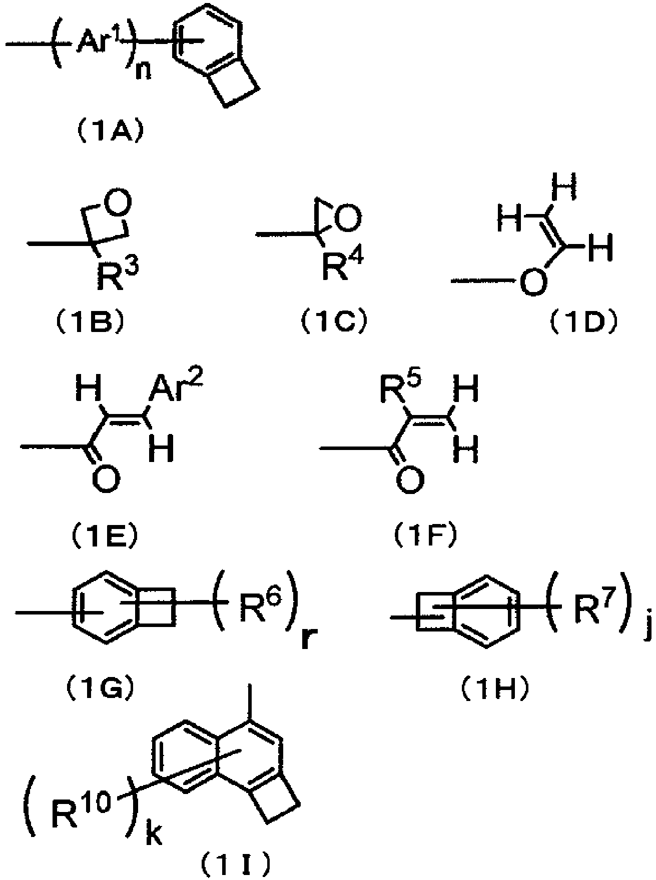
where in formula (1A), Ar¹ is an optionally substituted aromatic hydrocarbon group or an optionally substituted heteroaromatic group,
n is an integer of 1 to 6,
n Ar¹'s are optionally the same or different from each other, a benzocyclobutene ring in formula (1A) optionally contains one or more substituents, the one or more substituents are optionally taken together to form a ring,
in formulae (1B) to (1I), R³ to R⁵ are each a hydrogen atom or an alkyl group,
R⁶, R⁷, and R¹⁰ are each a hydrogen atom, an alkyl group, or an alkoxy group,
r and j are each an integer of 1 to 5, k is an integer of 1 to 7,
when r is 2 or more, multiple R⁶'s are optionally the same or different from each other, adjacent R⁶'s are optionally taken together to form a ring,
when j is 2 or more, multiple R⁷'s are optionally the same or different from each other, adjacent R⁷'s are optionally taken together to form a ring,
when k is 2 or more, multiple R¹⁰'s are optionally the same or different from each other, and
Ar² is an optionally substituted aromatic hydrocarbon group or an optionally substituted heteroaromatic group.

3. The organic photodiode according to Claim 1 or 2, wherein the groups that form the mutual bonds between the carbon atoms of the side chains at 230°C are each a group that undergoes ring-opening polymerization.

4. The organic photodiode according to any one of Claims 1 to 3, wherein the n-type semiconductor is represented by formula (4) illustrated below: 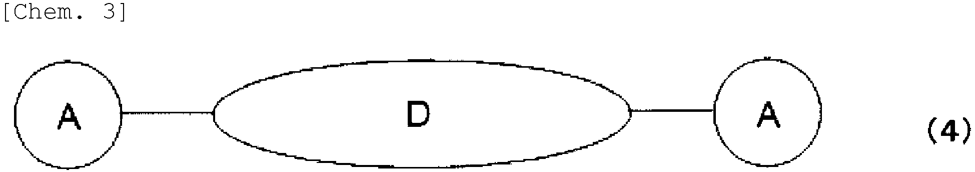 where in formula (4), D is a donor site containing an polycyclic aromatic moiety, and each A is an acceptor site containing a malononitrile group.

5. The organic photodiode according to any one of Claims 1 to 4, wherein the n-type semiconductor is represented by formula (5) illustrated below: 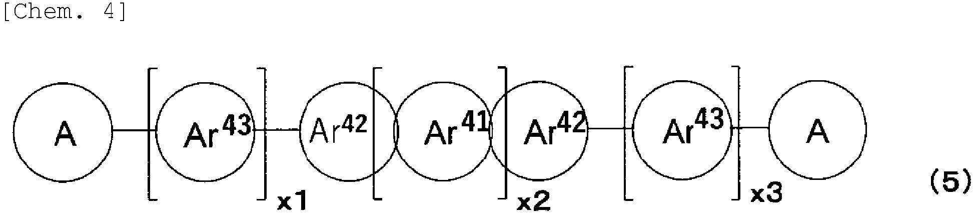
where in formula (5), each Ar⁴¹ is independently represented by any of formulae (5a-1) to (5g-1) illustrated below,
each Ar⁴² is independently represented by any of formulae (5a-2) to (5d-2) illustrated below,
each Ar⁴³ is independently represented by any of formulae (5a-3) to (5d-3) illustrated below, 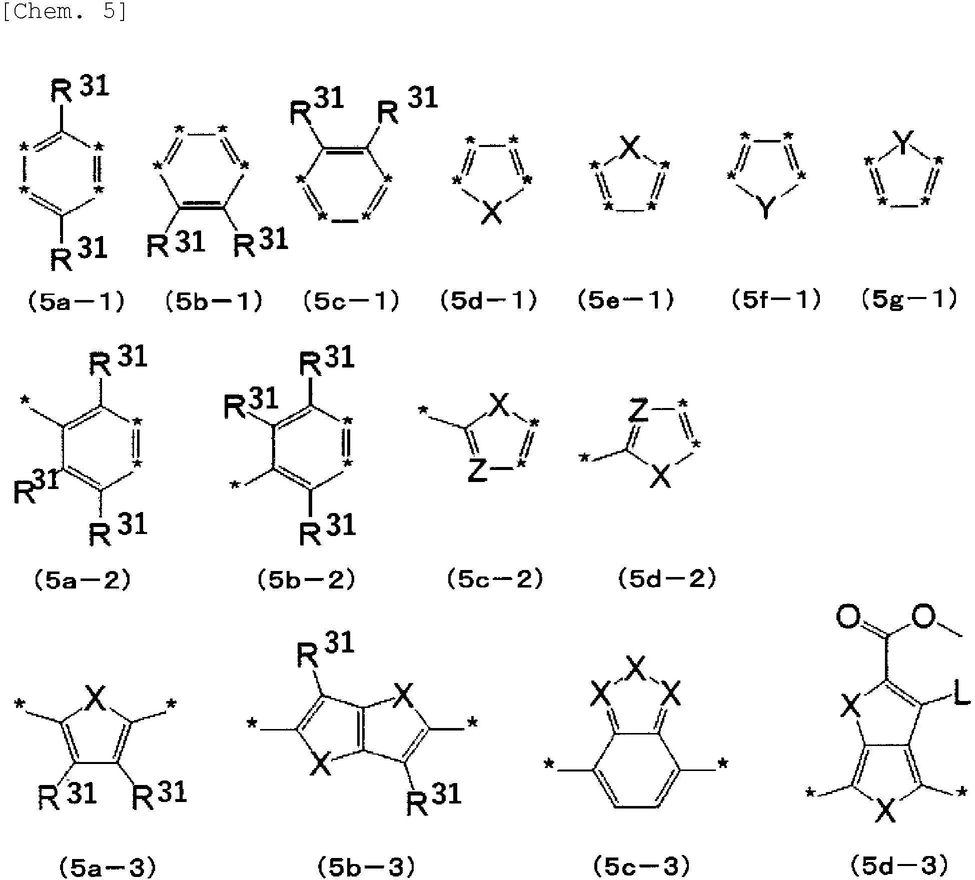
where in formulae (5a-1) to (5g-1), (5a-2) to (5d-2), and (5a-3) to (5d-3), each * is a binding site,
each X is C=O, O, S, or Se,
Y is CR³¹R³¹, SiR³¹R³¹, GeR³¹R³¹, NR³¹, or C=O,
each Z is CR³¹ or N,
L is R³¹ or a halogen atom,
each R³¹ is independently a hydrogen atom, an optionally branched alkyl group having 1 to 30 carbon atoms, an optionally branched alkoxy group having 1 to 30 carbon atoms, or a phenyl group optionally substituted with an optionally branched alkyl group having 1 to 30 carbon atoms and/or an optionally branched alkoxy group having 1 to 30 carbon atoms,
each A is an acceptor site containing a malononitrile group,
x1 is 0 or 1, x2 is an integer of 1 to 6, x3 is 0 or 1, and
in formula (5), formulae (5f-1) and (5g-1) are not adjacent to each other.

6. The organic photodiode according to Claim 4 or 5, wherein each A that is the acceptor site containing the malononitrile group is represented by any of formulae (5A) to (5C) illustrated below: 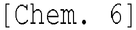 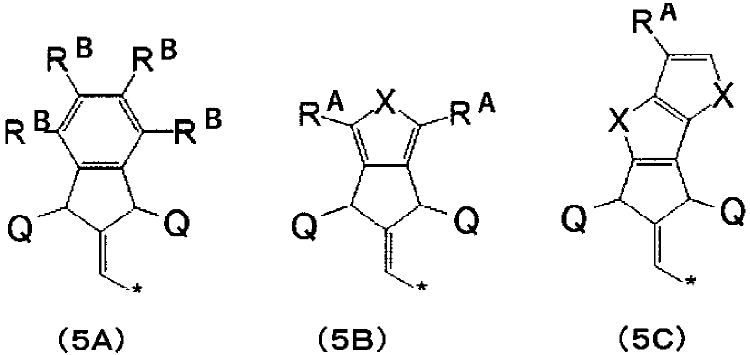
where in formulae (5A) to (5C), each * is a binding site,
each Q is a malononitrile group or O=, at least one of Q's is a malononitrile group,
each X is C=O, O, S, or Se,
each R^{A} is independently a hydrogen atom, a halogen atom, an optionally branched alkyl group having 1 to 30 carbon atoms, an optionally branched alkoxy group having 1 to 30 carbon atoms, or a phenyl group optionally substituted with an optionally branched alkyl group having 1 to 30 carbon atoms and/or an optionally branched alkoxy group having 1 to 30 carbon atoms, and
each R^{B} is defined the same as R^{A}, or adjacent R^{B}'s are taken together to form a six-membered aromatic ring.

7. The organic photodiode according to any one of Claims 1 to 6, wherein the polymer compound contains, as a partial structure, a monovalent or di- or higher valent group derived from a fluorene ring.

8. The organic photodiode according to any one of Claims 1 to 7, wherein the polymer compound has a weight-average molecular weight (Mw) of 20,000 or more and a polydispersity index (Mw/Mn) of 2.5 or less (where Mn is a number-average molecular weight).

9. The organic photodiode according to any one of Claims 1 to 8, wherein the polymer compound contains a repeat unit represented by formula (3) illustrated below, 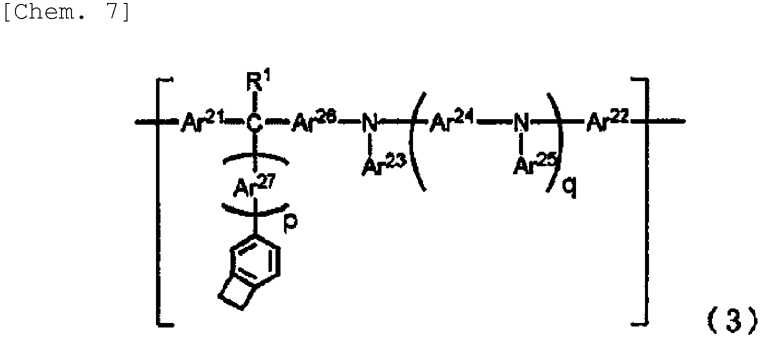
where in formula (3), p is an integer of 1 or more and 6 or less, q is an integer of 0 or more and 3 or less,
Ar²¹ and Ar²² are each independently a direct bond, an optionally substituted aromatic hydrocarbon group, or an optionally substituted heteroaromatic group,
Ar²³ to Ar²⁷ are each independently an optionally substituted aromatic hydrocarbon group or an optionally substituted heteroaromatic group,
R¹ is a hydrogen atom, an optionally substituted alkyl group having 1 to 24 carbon atoms, an optionally substituted alkoxy group having 1 to 24 carbon atoms, an optionally substituted aromatic hydrocarbon group, or an optionally substituted heteroaromatic group,
p Ar²⁷'s are optionally the same or different from each other, q Ar²⁴ are optionally the same or different from each other, q Ar²⁵ are optionally the same or different from each other, and Ar²¹ and Ar²² are not both direct bonds.

10. The organic photodiode according to any one of Claims 1 to 9, wherein the polymer compound contains 0.01 or more and 3 or less groups represented by formula (1) per molecular weight of 1,000.

11. The organic photodiode according to any one of Claims 1 to 10, wherein in the n-type semiconductor, the percentage of an n-type semiconductor having a fullerene skeleton is 10% or less by weight based on an n-type semiconductor having no fullerene skeleton.

12. The organic photodiode according to any one of Claims 1 to 11, wherein in the n-type semiconductor, substantially no n-type semiconductor having a fullerene skeleton is contained.

13. An infrared CMOS sensor, comprising the organic photodiode according to any one of Claims 1 to 12.
